# EUROPEAN PATENT APPLICATION

(11) **EP 2 562 551 A1**
(43) Date of publication of application: **27.02.2013**
(21) Application number: 11765333.7
(22) Date of filing: 15.03.2011
(51) Int. Cl.: G01R 15/20, H01F 38/28

(54) **MAGNETIC CORE, CURRENT SENSOR PROVIDED WITH THE MAGNETIC CORE, AND CURRENT MEASURING METHOD**

(30) Priority: 15.03.2011 JP 2011057281; 31.03.2010 JP 2010081555
(71) Applicant: Omron Corporation, Kyoto-shi, Kyoto 600-8530 (JP)
(72) Inventor: NAKA, Mamiko, KYOTO-SHI, KYOTO 600-8530 (JP); OKA, Kazunari, KYOTO-SHI, KYOTO 600-8530 (JP); YAMASHITA, Tsukasa, KYOTO-SHI, KYOTO 600-8530 (JP); ITODA, Shuichi, KYOTO-SHI, KYOTO 600-8530 (JP)
(74) Representative: Kilian Kilian & Partner
(86) International application number: PCT/JP2011/056119
(87) International publication number: WO 2011/125431

(57) **Abstract**

(EN)Disclosed is a magnetic core (1) to be used in a current sensor, which is provided with a first open end plane (3a), which has a first element holding hole (5a) for holding a magnetoelectric conversion element (20) formed therein; and a second open end plane (3b), which has a second element holding hole (5b) for holding the magnetoelectric conversion element (20) formed therein, and which faces the first open end plane (3a). With such configuration, the magnetic core (1) can improve the detection sensitivity of the current sensor.

## Description

### TECHNICAL FIELD

The present invention relates to a magnetic core capable of enhancing detection sensitivity of a current sensor, a current sensor provided with the magnetic core, and a current measuring method.

### BACKGROUND ART

In recent years, current sensors are in use in a large number of industrial fields, and a demand for high sensitivity, and the like is in increase year by year. Hence a variety of current sensors have been developed for the purpose of realizing high sensitivity, and one example thereof is disclosed in Japanese Unexamined Patent Publication No. H10-232259.

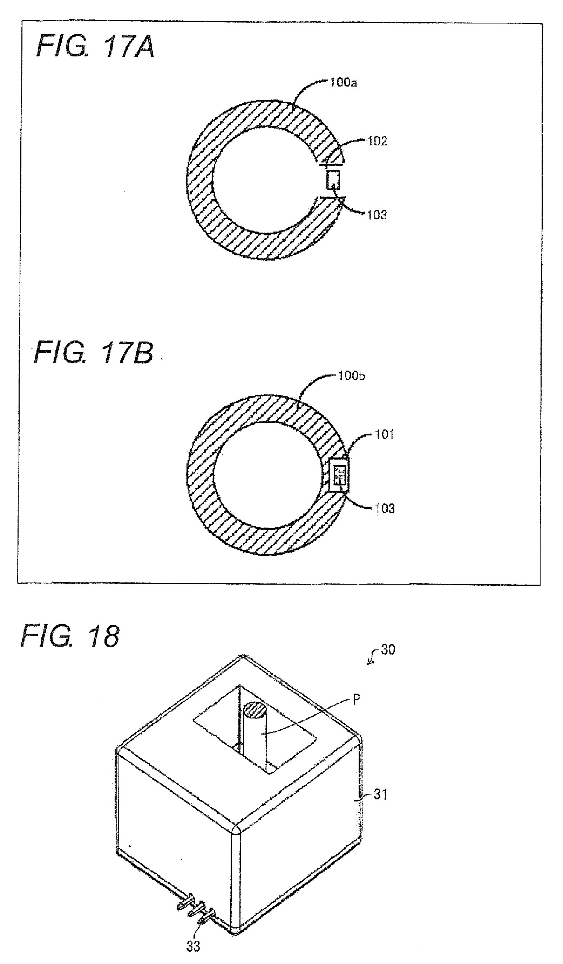

A current leakage sensor of Japanese Unexamined Patent Publication No. H10-232259 is configured of: a sensor which is made up of a ring-line magnetic body (magnetic core) and senses a change in magnetic field; a magnetic impedance element which is added to the sensor and whose impedance changes in accordance with a variation in magnetic field that occurs in the sensor; and a detector which detects a change in impedance of the magnetic impedance element. FIG. 17 is a view showing a structure of the conventional magnetic core described in Japanese Unexamined Patent Publication No. H10-232259. FIG. 17A is a schematic view showing a state where a cut-off section 101 is provided in a magnetic core 100a, and a magnetic impedance element 103 is placed in the cut-off section 101. Further, FIG. 17B is a schematic view showing a state where a notch section 102 is provided in the magnetic core 100a, and the magnetic impedance element 103 is placed on the notch section 102.

With the above configuration, a current sensor is realized which more efficiently transmits a change in magnetic field of the magnetic core 100a (100b) to the magnetic impedance element 103.

### SUMMARY OF THE INVENTION

### PROBLEMS TO BE SOLVED BY THE INVENTION

However, the magnetic core 100a (100b) of Japanese Unexamined Patent Publication No. H10-232259 has such a problem as follows.

The magnetic core 100a of FIG. 17A is provided with the cut-off section 101 that cuts off the magnetic core 100a, and the magnetic impedance element 103 is placed in the cut-off section 101. This has to make a width of the cut-off section 101 large, thus causing deterioration in sensitivity of the magnetic core 100a. The current leakage sensor provided with the magnetic core 100a of FIG. 17A thus has a problem of having low detection sensitivity.

The magnetic core 100b of FIG. 17B is formed with the magnetic core 100b that notches part of the magnetic core 100b along the outer edge of the magnetic core 100b, and the magnetic impedance element 103 is placed in the notch section 102. However, with that structure, a magnetic flux is resistant to leakage from the magnetic core 100b, and hence a magnetic flux detected by the magnetic impedance element 103 is also minute. The current leakage sensor provided with the magnetic core 100b of FIG. 17B thus has a problem of having low detection sensitivity.

As thus described, the current leakage sensor provided with the conventional magnetic core 100a (100b) has a problem of having low sensitivity, causing a value to be detected buried in noise at the time of measuring a current on a several tens of mA level.

It is to be noted that a current sensor obtained seeking high sensitivity is also disclosed in Japanese Unexamined Patent Publication No. 2005-49311. However, the current sensor of Japanese Unexamined Patent Publication No. 2005-49311 shields a magnetic core with a shield plate to enhance noise resistance, and is disadvantageous in bringing about another problem of increases in size and cost of the current sensor.

The present invention was made to solve the above problems, and has an object to provide a magnetic core capable of enhancing detection sensitivity of a current sensor, the current sensor provided with the magnetic core, and a current measuring method.

### MEANS FOR SOLVING THE PROBLEM

In order to solve the above problems, a magnetic core according to the present invention is a magnetic core used for a current sensor, having: a first open end plane which is formed with a first element holding hole for holding a magnetoelectric conversion element; and a second open end plane which is formed with a second element holding hole for holding the magnetoelectric conversion element, and is opposed to the first open end plane.

The magnetic core according to the present invention has the first open end plane and the second open end plane which are opposed to each other. Then, the first element holding hole is formed on the first open end plane, the second element holding hole is formed on the second open end plane, and a magnetoelectric conversion element is held in the first element holding hole and the second element holding hole.

Therefore, due to the presence of the first open end plane and the second open end plane, namely the presence of a void section (hereinafter referred to as a "magnetic flux leakage section") between the first open end plane and the second open end plane, a magnetic flux is prone to leakage from the magnetic core toward the first element holding hole and the second element holding hole, and the magnetoelectric conversion element held in the first element holding hole and the second element holding hole can sense the leakage of the magnetic flux.

In addition, while the sensitivity of the magnetic core is more favorable with lower magnetic resistance of the magnetic flux leakage section, the magnetic resistance of the magnetic flux leakage section is lower with a smaller width of the magnetic flux leakage section (distance between the first open end plane and the second open end plane). In this respect, in a magnetic core according to the present invention, the magnetoelectric conversion element is held in the first element holding hole and the second element holding hole which are formed in the first open end plane and the second open end plane. Therefore, it is not necessary to make large the distance between the first open end plane and the second open end plane to such a degree that the magnetoelectric conversion element is held therebetween. That is, due to the presence of the element holding hole, it is possible to make small the distance between the first open end plane and the second open end plane without consideration of a space for the magnetoelectric conversion element to be placed. Accordingly, in the magnetic core according to the present invention, the magnetic flux leakage section has a small width and thus causes magnetic resistance of the magnetic flux leakage section to decrease, thereby allowing improvement in sensitivity of the current sensor that uses the magnetic core.

For such a reason, the magnetic core according to the present invention can solve the conventional problem described with reference to FIG. 17A (problem that the width of the cut-off section has to be made large for providing the magnetoelectric conversion element in the cut-off section, accompanied by deterioration in sensitivity of the magnetic core).

Further, in the magnetic core according to the present invention, the first element holding hole and the second element holding hole are formed not in positions along an outer edge of the magnetic core where a magnetic flux is resistant to leakage from the magnetic core, but on the first open end plane and the second open end plane. For the above reason, in the magnetic core according to the present invention, the magnetoelectric conversion element is held in the first element holding hole and the second element holding hole where a magnetic flux is prone to leakage from the magnetic core, whereby it is possible to collect a larger amount of magnetic flux generated due to a minute current, so as to improve the sensitivity.

Therefore, the magnetic core according to the present invention can solve the conventional problem described with reference to FIG. 17B (problem that, due to placement of the magnetoelectric conversion element in the notch section formed along the outer edge of the magnetic core, a magnetic flux is resistant to leakage from the magnetic core and the magnetoelectric conversion element detects a minute magnetic flux, thereby to cause deterioration in sensitivity of the magnetic core).

As thus described, with the above configuration formed, a magnetic core capable of enhancing the detection sensitivity of the current sensor can be realized as the magnetic core according to the present invention.

In addition, the magnetic core according to the present invention also exerts such an effect as follows.

That is, the conventional current sensor is influenced by an external magnetic field at the time of measuring a current of several tens of mA since the magnetic core itself does not have a structure (function) to realize noise resistance, and hence the current sensor cannot perform current measurement with high detection sensitivity.

However, in the magnetic core according to the present invention, the magnetic flux leakage section serves as a shield against an external magnetic field that is generated due to the earth's magnetism, an external current or the like. Hence the magnetic core according to the present invention can even solve the conventional problem that covering the magnetic core with a shield member interferes with reduction in size and cost.

Further, the magnetic core according to the present invention may be configured that the magnetoelectric conversion element is held in the first element holding hole and the second element holding hole such that a magnetic sensing direction of the magnetoelectric conversion element is a circumferential direction of the magnetic core.

With the above configuration formed, it is possible to select a magnetoelectric conversion element with a small size in a thickness direction of the magnetoelectric conversion element (thickness direction of the magnetic core which is vertical to the circumferential direction of the magnetic core), so as to make small widths of the first element holding hole and the second element holding hole, which hold the magnetoelectric conversion element, in the thickness direction of the magnetic core. With smaller widths of the first element holding hole and the second element holding hole in the thickness direction of the magnetic core, a magnetic flux that leaks from the magnetic core is amplified, and hence with the above configuration formed, it is possible to enhance the sensitivity of the magnetoelectric conversion element. Accordingly, a magnetic core capable of further enhancing the detection sensitivity of the current sensor can be realized as the magnetic core according to the present invention.

Further, the magnetic core according to the present invention may be configured that the first element holding hole and the second element holding hole are filled with a low permeability material having a lower permeability than the magnetic core.

Filling the first element holding hole and the second element holding hole with the low permeability material allows improvement in sensitivity with the same magnification as a relative permeability of the low permeability material.

Accordingly, with the above configuration formed, it is possible to realize a magnetic core capable of further enhancing the detection sensitivity of the current sensor.

Further, the magnetic core according to the present invention may be configured that a space between the first open end plane and the second open end plane is filled with a low permeability material having a lower permeability than the magnetic core.

With a lower value of magnetic resistance between the first open end plane and the second open end plane, the sensitivity of the entire magnetic core becomes higher. Accordingly, with the above configuration formed, it is possible to realize a magnetic core capable of further enhancing the detection sensitivity of the current sensor.

Further, in the magnetic core according to the present invention, the low permeability material may be a ferrite-containing epoxy resin, a magnetic fluid or air.

As typical magnetic core materials, PB permalloy, PC permalloy, amorphous, a silicon steel plate and the like are known. Any material can be used for the magnetic core according to the present invention. Examples of the low permeability material having a lower permeability than the magnetic core may include the ferrite-containing epoxy resin, the magnetic fluid and the air.

Therefore, filling the first element holding hole and the second element holding hole with the ferrite-containing epoxy resin, the magnetic fluid or the air leads to realization of a magnetic core capable of further enhancing the detection sensitivity of the current sensor.

Further, in the magnetic core according to the present invention, when a side surface opposed to a side surface forming the second element holding hole among side surfaces forming the first element holding hole is regarded as a first side surface and a side surface opposed to the first side surface among side surfaces forming the second element holding hole is regarded as a second side surface, the first element holding hole and the second element holding hole preferably have hole widths in a thickness direction of the held magnetoelectric conversion element not more than 1.75 times as large as the distance between the first side surface and the second side surface.

It was found that, regardless of the distance between the first open end plane and the second open end plane, when the hole width is more than 1.75 times as large as the distance between the side surfaces, the effect of making small the distance between the first open end plane and the second open end plane is lost.

Accordingly, with the above configuration formed, such an effect is exerted that a large amount of magnetic flux can be collected in the magnetoelectric conversion element even with a minute current.

Further, in the magnetic core according to the present invention, the distance between the first open end plane and the second open end plane is preferably smaller than 2 mm.

In light of a size of a typical magnetoelectric conversion element, when the distance between the first open end plane and the second open end plane is not smaller than 2mm, there is a space where the magnetoelectric conversion element can be arranged even without the presence of the first element holding hole and the second element holding hole.

Thereat, with the above configuration formed, such an effect is exerted that the magnetoelectric conversion element can be held in the first element holding hole and the second element holding hole even when the distance between the first open end plane and the second open end plane is smaller than 2 mm, and the magnetoelectric conversion element can reliably sense a magnetic flux leaking from the magnetic core to the first element holding hole and the second element holding hole.

Moreover, the magnetic core according to the present invention may be configured that parts of the first open end plane and the second open end plane are in contact with each other.

As the structure of a typical magnetic core, there are known a variety of types such as an integrated type, a laminated type and a docked type, and the magnetic core according to the present invention is adoptable to any type. However, there are cases where it is practically difficult to manufacture and process the magnetic core of any type without any contact between the first open end plane and the second open end plane.

In this regard, in the magnetic core according to the present invention, even when parts of the first open end plane and the second open end plane are in contact with each other, since a magnetic flux leaks from the magnetic core to the first element holding hole and the second element holding hole through the magnetic flux leakage section, the magnetoelectric conversion element can sense the leakage of the magnetic flux. Therefore, in the case where it is practically difficult to manufacture and process the magnetic core of any type without any contact between the first open end plane and the second open end plane, the magnetic core can be used as it is. Accordingly, it is possible to realize a magnetic core capable of further enhancing the detection sensitivity of the current sensor, while also eliminating the need for additional step in the manufacturing and processing and realizing low cost.

It may be configured that the first element hooding hole and the second element holding hole are respectively extended on the first open end plane and the second open end plane along a parallel direction to the thickness direction of the magnetic core.

Further, the magnetic core according to the present invention may be configured that the first element holding hole and the second element holding hole are respectively extended on the first open end plane and the second open end plane along a vertical direction to the thickness direction of the magnetic core.

As described above, as the structure of the typical magnetic core, there are known a variety of types such as the integrated type, the laminated type and the docked type.

Therefore, for example when a stacked magnetic core is to be produced, a plurality of layers formed with the first element holding hole and the second element holding hole in the same place are prepared, and those layers are sequentially stacked so that the magnetic core according to the present invention can be manufactured with ease at low cost. Also when the magnetic core of the integrated type or the docked type is to be produced, with the above configuration formed, the magnetic core can be manufactured with ease at low cost. This can realize a magnetic core suitable for mass production.

Further, the current sensor according to the present invention is preferably configured to be provided with the magnetic core.

With the above configuration formed, it is possible to realize a current sensor capable of performing high sensitive measurement.

Moreover, the current measuring method according to the present invention is preferably measuring a current value of a current flowing through a measuring object wire by means of a current sensor provided with the magnetic core.

With the above configuration formed, it is possible to realize a current measuring method capable of performing high sensitive measurement.

### EFFECTS OF THE INVENTION

As described above, the magnetic core according to the present invention is configured to have: a first open end plane which is formed with a first element holding hole for holding a magnetoelectric conversion element; and a second open end plane which is formed with a second element holding hole for holding the magnetoelectric conversion element, and is opposed to the first open end plane.

It is therefore possible to realize a magnetic core capable of enhancing the detection sensitivity of the current sensor.

### BRIEF DESCRIPTION OF THE DRAWINGS

FIG. 1 is a view showing a schematic configuration of a magnetic core according to the present invention, where FIG. 1A shows a top view of the magnetic core, FIG. 1B shows a perspective view of the magnetic core, and FIG. 1C shows an expanded view of a characteristic section of the magnetic core;
FIG. 2 is a view for explaining an example of another magnetic core according to the present invention;
FIG. 3 is a view for explaining a still another example of the magnetic core according to the present invention;
FIG. 4 is a view for explaining a method for forming the magnetic core according to the present invention, where FIG. 4A shows a top view of the magnetic core, and FIGS. 4B and 4C show sectional views along A-A' in FIG. 4A;
FIG. 5 is a view for explaining a method for forming the magnetic core according to the present invention, where FIG. 5A is a view for explaining an integrated type magnetic core, FIG. 5B is a view for explaining a docked type magnetic core, and FIG. 5C is a view for explaining another docked type magnetic core;
FIG. 6 is a view for explaining a shape of the magnetic core according to the present invention, where FIG. 6A is a view for explaining a ring-shaped magnetic core, and FIG. 6B is a view for explaining a rectangular-shaped magnetic core;

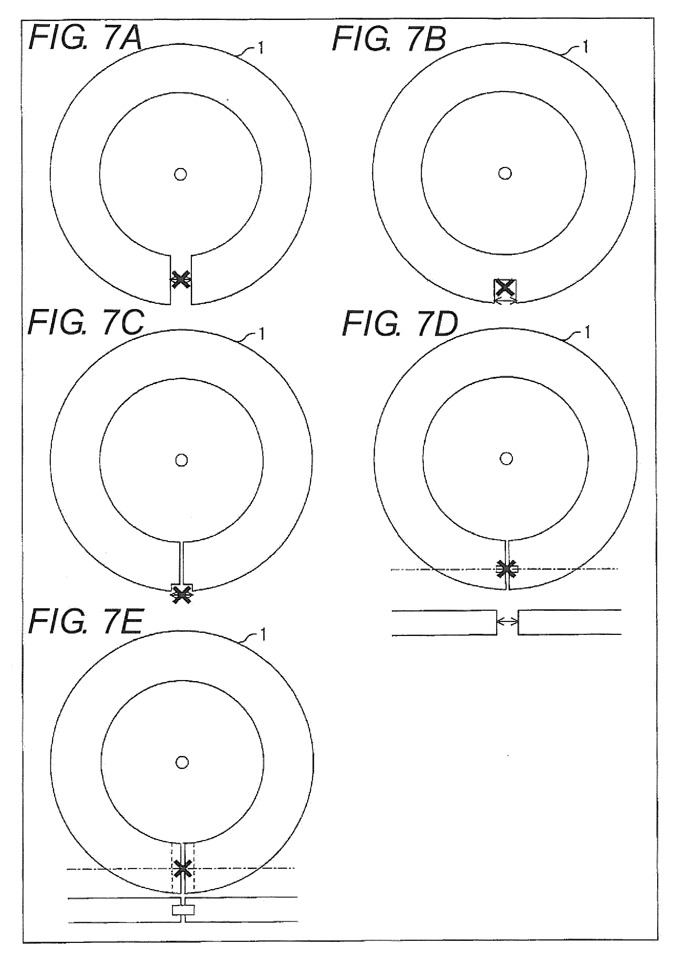

FIG. 7 is a view showing results of measurement of a magnetic flux density by means of a known magnetic core and the magnetic core according to the present invention, where FIG. 7A is a view showing a result of measurement by means of the magnetic core of FIG. 17A, FIG. 7B is a view showing a result of measurement by means of the known magnetic core of FIG. 17B, FIG. 7C is a view showing a result of measurement by means of a magnetic core obtained by further providing a void section in the magnetic core of FIG. 7B, FIG. 7D is a view showing a result of measurement by means of a magnetic core in the case of an element holding hole being formed in parallel with a measuring object wire, and FIG. 7E is a view showing a result of measurement by means of a magnetic core in the case of an element holding hole being formed in a vertical direction a measuring object wire.
FIG. 8 is a view for explaining improvement in measurement sensitivity for a magnetic flux density by means of the magnetic core according to the present invention, as well as a view showing a positional relation of the magnetoelectric conversion element with respect to the magnetic flux leakage section.
FIG. 9 is a view showing results of measurement of a magnetic flux density by means of the magnetic core according to the present invention, where FIG. 9A is a view for showing a definition of each symbol, FIG. 9B is a graph showing a magnetic flux density at the time of changing L2, and FIG. 9C is a graph showing a magnetic flux density at the time of changing L1;
FIG. 10 is a view showing magnetic cores having a gap structure and an abutting structure, where FIG. 10A is a view showing a magnetic core having the gap structure, FIG. 10B is a view showing a magnetic core having the abutting structure in which the first open end plane and the second open end plane are in contact with each other at two points, and FIG. 10C is a view showing a magnetic core having the abutting structure in which the first open end plane and the second open end plane are in contact with each other at 16 points;
FIG. 11 is a view showing results of measurement of a magnetic flux density by means of the magnetic core according to the present invention, where FIG. 11A is a view for showing a definition of each symbol, FIG. 11B is a graph showing a magnetic flux density at the time of setting L1 to 1 mm, FIG. 11C is a graph showing a magnetic flux density at the time of setting L1 to 1.5 mm, and FIG. 11D is a graph showing a magnetic flux density at the time of setting L1 to 2 mm;

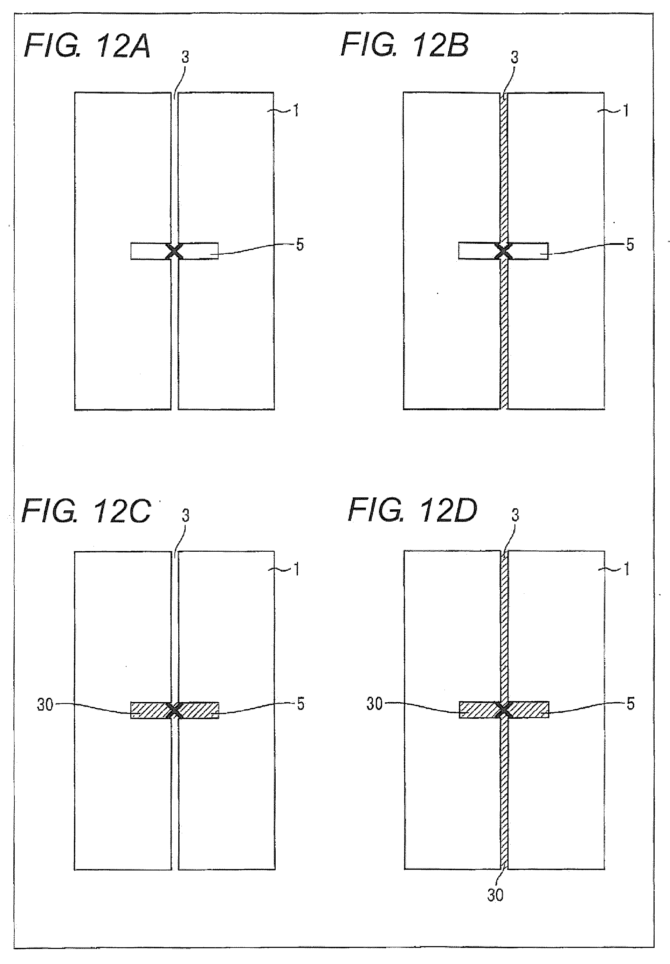

FIG. 12 is a view for explaining the sensitivity of measurement of a magnetic flux density by means of the magnetic core according to the present invention is influenced by the presence or absence of a magnetic agent, wherein FIG. 12A is a view showing the case of neither the magnetic flux leakage section nor the element holding hole being filled with the magnetic agent, FIG. 12B is a view showing the case of only the magnetic flux leakage section being filled with the magnetic agent, FIG. 12C is a view showing the case of only the element holding hole being filled with the magnetic agent, and FIG. 12D is a view showing the case of both the magnetic flux leakage section and the element holding hole being filled with the magnetic agent;

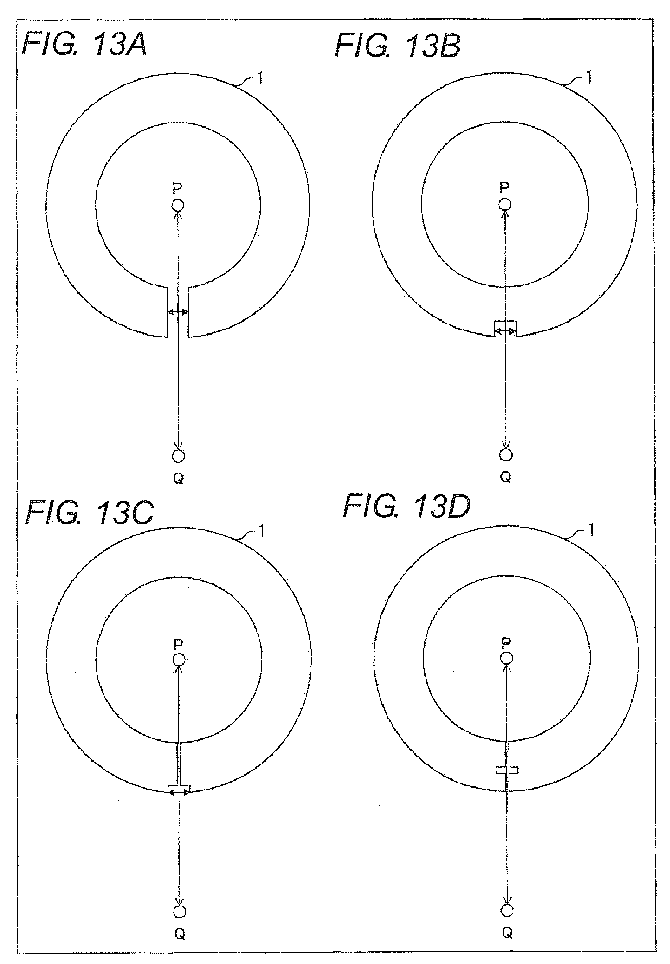

FIG. 13 is a view showing results of measurement of a magnetic flux density by means of a known magnetic core and the magnetic core according to the present invention, where FIG. 13A is a view showing a result of measurement by means of a known magnetic core of FIG. 17A, FIG. 13B is a view showing a result of measurement by means of a known magnetic core of FIG. 17B, FIG. 13C is a view showing a result of measurement by means of a magnetic core obtained by further providing a void section in the magnetic core of FIG. 13B, and FIG. 13D is a view showing a result of measurement by means of a magnetic core;
FIG. 14 is a view for explaining that noise resistance of the magnetic core according to the present invention is high;
FIG. 15 is a graph showing the relation between a thickness of the magnetic core and a measurement error;
FIG. 16 is a view showing an example where the magnetic core according to the present invention is applied to leakage detection of a power conditioner for a solar cell;
FIG. 17 is a view showing a structure of a conventional magnetic core, where FIG. 17A is a schematic view showing a state where the magnetic core is provided with a cut-off section and a magnetic impedance element is placed in the cut-off section, and FIG. 17B is a schematic view showing a state where the magnetic core is provided with a notch section and the magnetic impedance element is placed in the notch section;
FIG. 18 is an external view of a current sensor according to the present embodiment;
FIG. 19 is a perspective view of an internal structure of the current sensor according to the present embodiment;
FIG. 20 is one sectional view of an internal structure of the current sensor in a horizontal direction of FIG. 19 (right and left direction of the figure);
FIG. 21 is an exploded assembly diagram of the current sensor according to the present embodiment;
FIG. 22 is a block diagram for explaining an operation of the current sensor according to the present embodiment;
FIG. 23 is an external view of the current sensor according to the present embodiment used for leakage detection and measurement of a leakage amount;
FIG. 24 is a block diagram for explaining the operation of the current sensor according to the present embodiment in the case of the current sensor being used for leakage detection.
FIG. 25 shows one shape of the magnetic core according to the present embodiment, where FIG. 25A shows a top view and FIG. 25B shows a front view;
FIG. 26 shows the magnetic core of FIG. 25, where FIG. 26A shows a perspective view and FIG. 26B shows an expanded view of a magnetic flux leakage section and an element holding hole;
FIG. 27 shows one shape of the magnetic core according to the present embodiment, where FIG. 27A shows a top view and FIG. 27B shows a perspective view;
FIG. 28 shows one shape of the magnetic core according to the present embodiment, where FIG. 28A shows an elevational view, FIG. 28B shows a sectional view, and FIG. 28C shows a perspective view;
FIG. 29 shows one shape of the magnetic core according to the present embodiment, where FIG. 29A shows an elevational view, FIG. 29B shows a sectional view, and FIG. 29C shows a perspective view;
FIG. 30 shows one shape of the magnetic core according to the present embodiment, where FIG. 30A shows an elevational view, FIG. 30B shows a sectional view, and FIG. 30C shows a perspective view;
FIG. 31 shows one shape of the magnetic core according to the present embodiment, where FIG. 31A shows a top view and FIG. 31B shows a sectional view;
FIG. 32 shows one shape of the magnetic core according to the present embodiment, where FIG. 32A shows a top view and FIG. 32B shows a sectional view;
FIG. 33 shows one shape of the magnetic core according to the present embodiment, where FIG. 33A shows a top view and FIG. 33B shows a sectional view;
FIG. 34 shows one shape of the magnetic core according to the present embodiment, where FIG. 34A shows a perspective view and FIG. 34B shows a top view;
FIG. 35 shows one shape of the magnetic core according to the present embodiment, where FIG. 35A shows a perspective view and FIG. 35B shows a top view;
FIG. 36 shows one shape of the magnetic core according to the present embodiment, where FIG. 36A shows a top view and FIG. 36B shows an elevational view;
FIG. 37 shows one shape of the magnetic core according to the present embodiment, where FIG. 37A shows a top view and FIG. 37B shows an elevational view;
FIG. 38 shows one shape of the magnetic core according to the present embodiment, where FIG. 38A shows a perspective view of the magnetic core of FIG. 36 and FIG. 38B shows a perspective view of the magnetic core of FIG. 37;
FIG. 39 shows one shape of the magnetic core according to the present embodiment, where FIG. 39A shows a top view and FIG. 39B shows a perspective view;
FIG. 40 shows one shape of the magnetic core according to the present embodiment, where FIG. 40A shows a top view and FIG. 40B shows a perspective view;
FIG. 41 shows one shape of the magnetic core according to the present embodiment, where FIG. 41A shows a top view and FIG. 41B shows a perspective view;
FIG. 42 shows one shape of the magnetic core according to the present embodiment, where FIG. 42A shows a top view and FIG. 42B shows a perspective view;
FIG. 43 shows one shape of the magnetic core according to the present embodiment, where FIG. 43A shows a top view and FIG. 43B shows a perspective view;
FIG. 44 shows one shape of the magnetic core according to the present embodiment, where FIG. 44A shows a top view and FIG. 44B shows a perspective view;
FIG. 45 shows one shape of the magnetic core according to the present embodiment, where FIG. 45A shows a top view and FIG. 45B shows a perspective view;
FIG. 46 shows one shape of the magnetic core according to the present embodiment, where FIG. 46A shows a top view and FIG. 46B shows a perspective view;
FIG. 47 shows one shape of the magnetic core according to the present embodiment, where FIG. 47A shows a perspective view and FIG. 47B shows an expanded view of a magnetic flux leakage section and an element holding hole;
FIG_{.} 48 shows one shape of the magnetic core according to the present embodiment, where FIG. 48A shows a perspective view and FIG. 48B shows an expanded view of a magnetic flux leakage section and an element holding hole; and
FIG. 49 is a view for explaining that the sensitivity of the current sensor provided with the magnetic core does not decrease even with the magnetic core having a small thickness, where FIG. 49A shows a perspective view, and FIG. 49B shows a schematic view.

### BEST MODE FOR CARRYING OUT THE INVENTION

Hereinafter, one embodiment of the present invention will be described with reference to the drawings. For the sake of convenience of explanation, a member having the same function as the member shown in the drawings is provided with the same symbol and its explanation will be omitted.

### [1. About magnetic core 1]

### [1-1. Schematic structure of magnetic core 1]

Hereinafter, a schematic structure of the magnetic core 1 according to the present embodiment will be described. It is to be noted that in order to facilitate understanding, a current sensor provided with the magnetic core 1 will be first described, and the schematic structure of the magnetic core 1 will then be described.

First, a description of a basic principle of the current sensor will be given below. A magnetic core formed of a magnetic body amplifies a magnetic field generated from a current of a measuring object wire. Next, the magnetoelectric conversion element detects a magnetic flux density of the amplified magnetic field, and converts it to an electric signal. Subsequently, the electric signal is processed in an output signal processing circuit, and a current value of the measuring object wire is measured.

It is to be noted that the magnetic core 1 is involved in the magnetic core of the current sensor, and examples of an application of the current sensor may include a current leakage sensor.

Further, the current sensor according to the present embodiment is applicable to a broad range of fields, such as leakage detection for a power conditioner that is a solar cell, a fuel cell or the like, monitoring of a battery loaded in a hybrid car, a plug-in hybrid car or the like, and monitoring of a battery of a data center UPS.

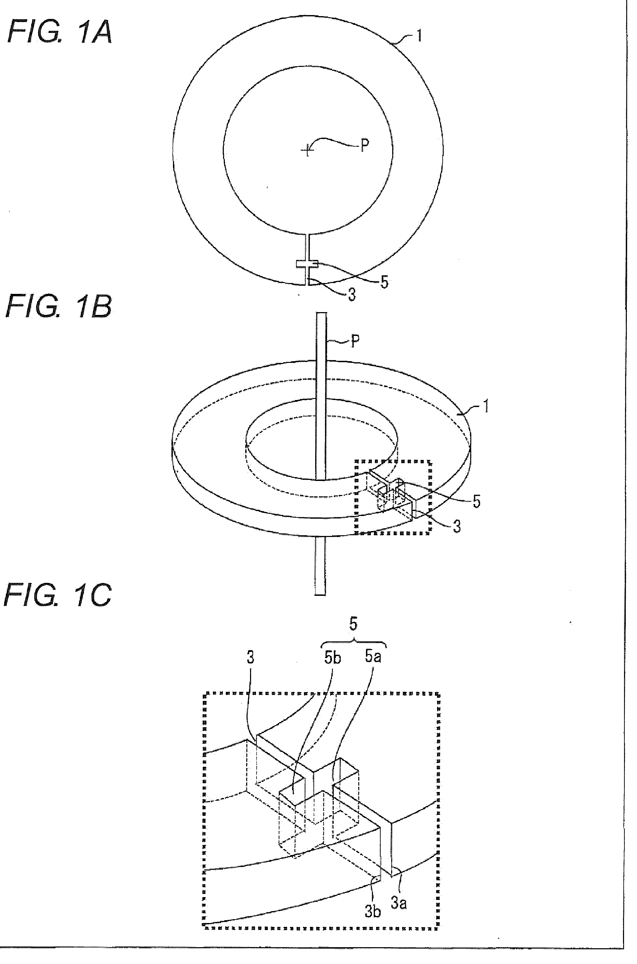

Hereinafter, a schematic structure of the magnetic core 1 will be described. FIG. 1 is a view showing a schematic configuration of the magnetic core 1, where FIG. 1A shows a top view of the magnetic core 1, FIG. 1B shows a perspective view of the magnetic core 1, and FIG. 1C shows an expanded view of a characteristic section of the magnetic core 1.

As shown in FIGS. 1A and 1B, the magnetic core 1 is arranged in ring shape so as to surround an axis in a current flowing direction in a measuring object wire P. Then, as shown in FIG. 1C, the magnetic core 1 has a first open end plane 3a formed with a first element holding hole 5a, and a second open end plane 3b formed with a second element holding hole 5b and second open end plane 3b opposed to the first open end plane 3a, and the first open end plane 3a and the second open end plane 3b are formed in parallel with the current flowing direction in the measuring object wire P.

As shown in FIG. 1C, the first element holding hole 5a is formed on the first open end plane 3a in parallel with the thickness direction of the magnetic core 1 (current flowing direction in the measuring object wire P). Similarly, the second element holding hole 5b is formed on the second open end plane 3b in parallel with the thickness direction of the magnetic core 1. Then, the first element holding hole 5a and the second element holding hole 5b are formed in rectangular groove shape in mutually opposed positions. In addition, although not shown, a magnetoelectric conversion element, which converts a magnetic flux generated by the magnetic core 1 to an electric signal, is held in the first element holding hole 5a and the second element holding hole 5b.

In the above, the schematic configuration of the magnetic core 1 was described. In the following description, the void section between the first open end plane 3a and the second open end plane 3b is referred to as a "magnetic flux leakage section 3". Further, when the first element holding hole 5a and the second element holding hole 5b are not distinguished from each other, those are simply referred to as a "element holding hole 5".

### [1-2. Another example]

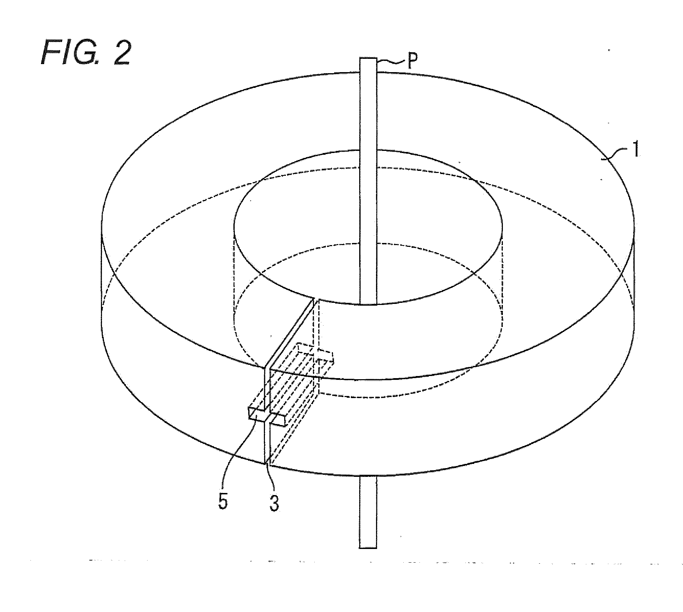

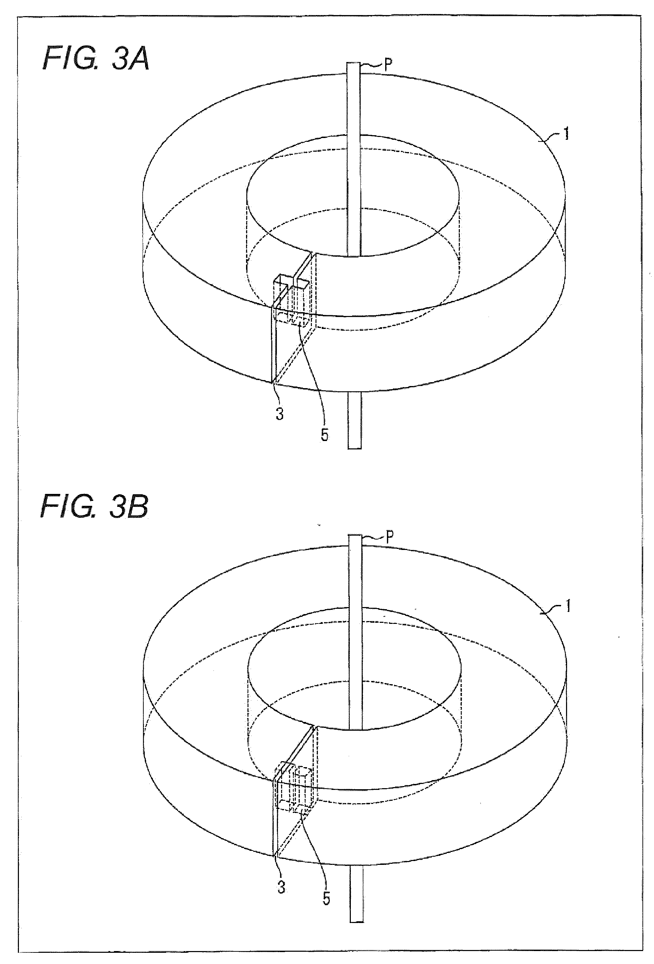

Next, another example of the magnetic core 1 will be described by means of FIGS. 2 and 3. It should be noted that, as for the contents described with reference to FIG. 1, its description will be omitted.

Fig. 2 is a view for explaining another example of the magnetic core 1. In the magnetic core 1 shown in the same figure, the element holding hole 5 is formed in a vertical direction to the thickness direction of the magnetic core 1. Further, not shown, the element holding hole 5 may be formed not in the horizontal and vertical direction to the thickness direction of the magnetic core 1, but in an oblique direction thereto. However, in light of the time and effort for manufacturing and processing of the magnetic core 1, the cost therefor, or the like, it is preferable to produce the magnetic core 1 with the structures shown in FIGS. 1 and 2.

FIG. 3 is a view for explaining a still another example of the magnetic core according to the present invention, where FIG. 3A shows a first modified example of the element holding hole 5 of FIG. 1, and FIG. 3B shows a second modified example of the element holding hole 5 of FIG. 1.

As shown in the figure, the element holding hole 5 of FIG. 3A is realized in a configuration where the lower side (lower side of the figure) of the element holding hole 5 of FIG. 1 is not present. Further, the element holding hole 5 of FIG. 3B is realized in a configuration where the upper side (upper side of the figure) and the lower side (lower side of the figure) of the element holding hole 5 of FIG. 1 is not present, but only the vicinity of its center is present. Even the magnetic core realized by having such a configuration can exert a later-mentioned effect, and hence it belongs to a category of the present embodiment.

### [1-3. Method for forming magnetic core 1, etc.]

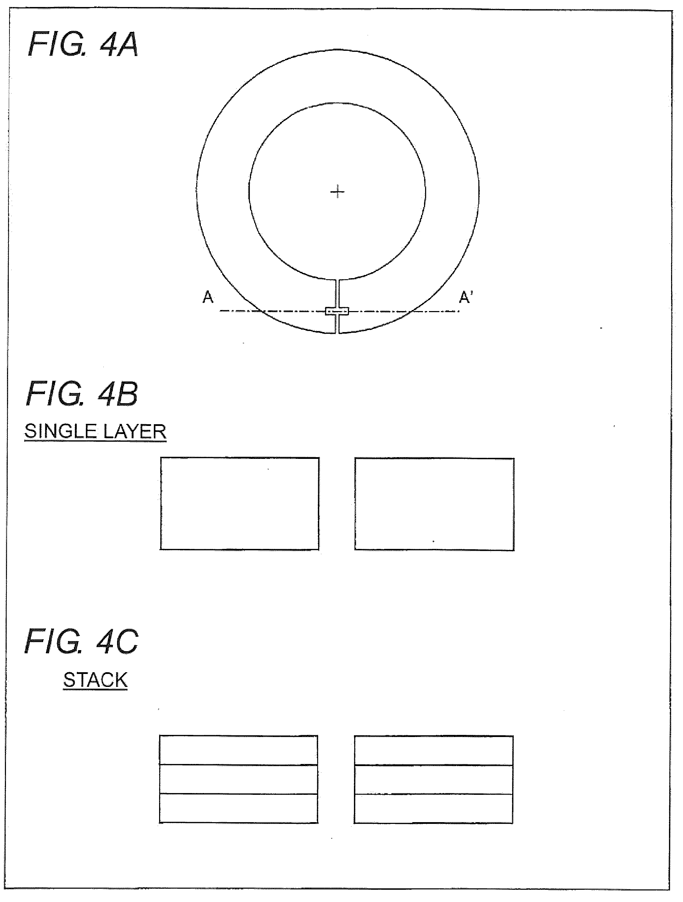

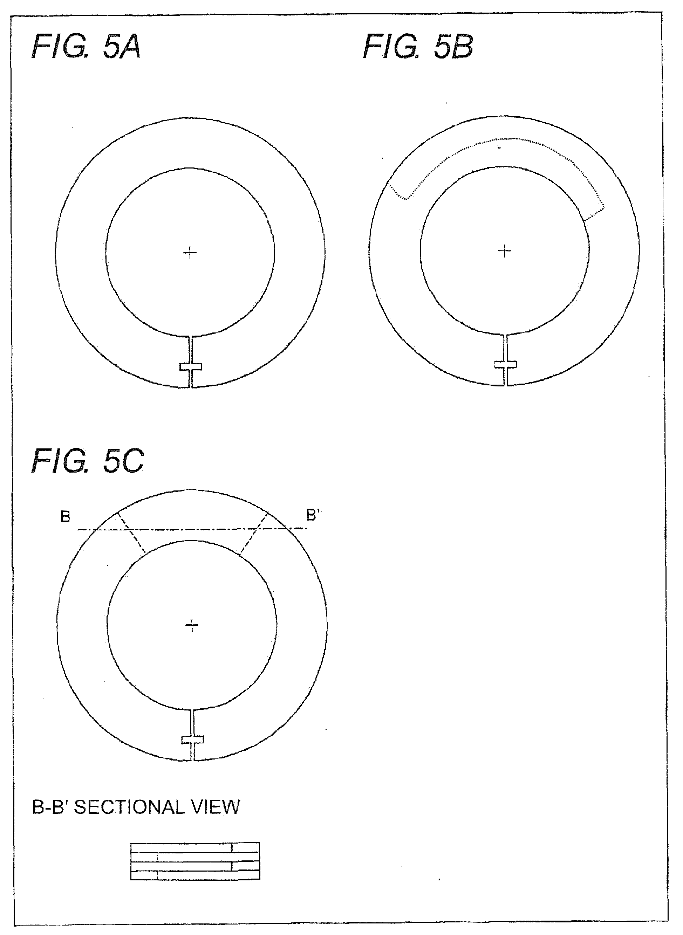

Next, a method for forming the magnetic core 1 will be described by means of FIGS. 4 and 5. FIG. 4 is a view for explaining a method for forming the magnetic core 1 according to the present invention, where FIG. 4A shows a top view of the magnetic core 1, and FIGS. 1B and 1C show sectional views along A-A' in FIG. 4A. As shown in FIGS. 4B and 4C, the magnetic core 1 may be formed of a single layer, or may be formed by stacking a plurality of layers.

FIG. 5 is a view for explaining a method for forming the magnetic core 1, where FIG. 5A is a view for explaining an integrated type magnetic core, FIG. 5B is a view for explaining a docked type magnetic core, and FIG. 5C is a view for explaining another docked type magnetic core. As shown in FIG. 5, the magnetic core 1 can be realized by a variety of types.

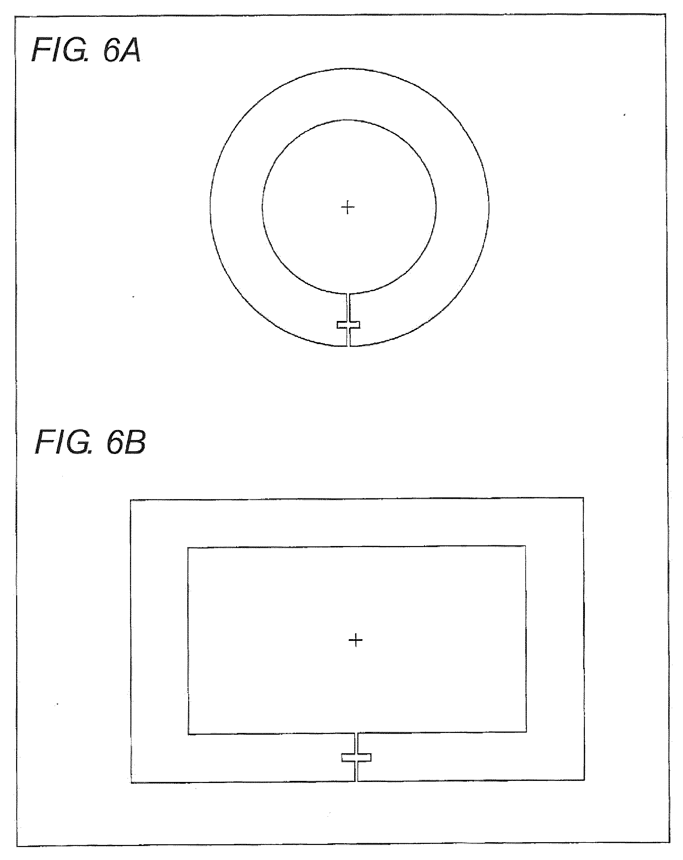

FIG. 6 is a view for explaining a shape of the magnetic core 1, where FIG. 6A is a view for explaining a ring-shaped magnetic core, and FIG. 6B is a view for explaining a rectangular-shaped magnetic core. As shown in FIG. 6, the magnetic core 1 can be realized by a variety of types.

Accordingly, the magnetic core 1 can be realized in a variety of structures and shapes, and for example, an appropriate change can be made, such as a change from the ring-shaped magnetic core described with reference to FIG. 1 and the like to the rectangular-shaped magnetic core.

Further, the magnetic core 1 may be realized in such a configuration.

Specifically, in the above, FIG. 1 and the like, it is described as assuming that the first open end plane 3a and the second open end plane 3b are held in parallel with each other and not in contact with each other (hereinafter, this structure may also be referred to as a "gap structure"). However, there are also cases where parts of the first open end plane 3a and the second open end plane 3b are in contact with each other (hereinafter, this structure may also be referred to as an "abutting structure"). This is because, as an actual condition in manufacturing and processing of the magnetic core, there can be cases where the first open end plane 3a and the second open end plane 3b are not in complete parallel with each other and parts of the first open end plane 3a and the second open end plane 3b are in contact with each other. Then, even when the magnetic core 1 has the abutting structure, a similar effect (details will be described later) is exerted, and hence the magnetic core 1 having the abutting structure also belongs to the category of the present embodiment.

### [2. A variety of measurement results regarding magnetic core 1]

Next, a variety of measurement results regarding magnetic core 1 will be described.

### [2-1. Data (1) on improvement in sensitivity]

First, it will be described in FIG. 7 that the measurement sensitivity for a magnetic flux density is improved by the magnetic core 1. FIG. 7 is a view showing results of measurement of a magnetic flux density by means of a known magnetic core and the magnetic core 1, where FIG. 7A shows a result of measurement by means of the magnetic core of FIG. 17A, FIG. 7B shows a result of measurement by means of the known magnetic core of FIG. 17B, and FIG. 7C shows a result of measurement by means of a magnetic core obtained by further providing a void section (corresponding to the magnetic flux leakage section 3 of the present embodiment) in the magnetic core of FIG. 7B. Moreover, FIG. 7D is a view showing a result of measurement by means of the magnetic core 1 in the case of the element holding hole 5 being formed in parallel with a measuring object wire, and FIG. 7E is a view showing a result of measurement by means of the magnetic core 1 in the case of the element holding hole 5 being formed in a vertical direction to a measuring object wire.

It is to be noted that a mark x shown in each figure indicates a measurement point of a magnetic flux density.

Further, conditions for measurement using the magnetic core shown in each figure, such as a size of the magnetic core and a current value (30mA) flowing through the measuring object wire, are made the same except for a shape of the magnetic core which is characteristic. Further, a width of the cut-off section provided in the magnetic core of FIG. 7A and widths of the notch sections provided in the magnetic cores of FIGS. 7B and 7C are made the same as widths of the element holding hole 5 provided in the magnetic core of FIGS. 7D and 7E.

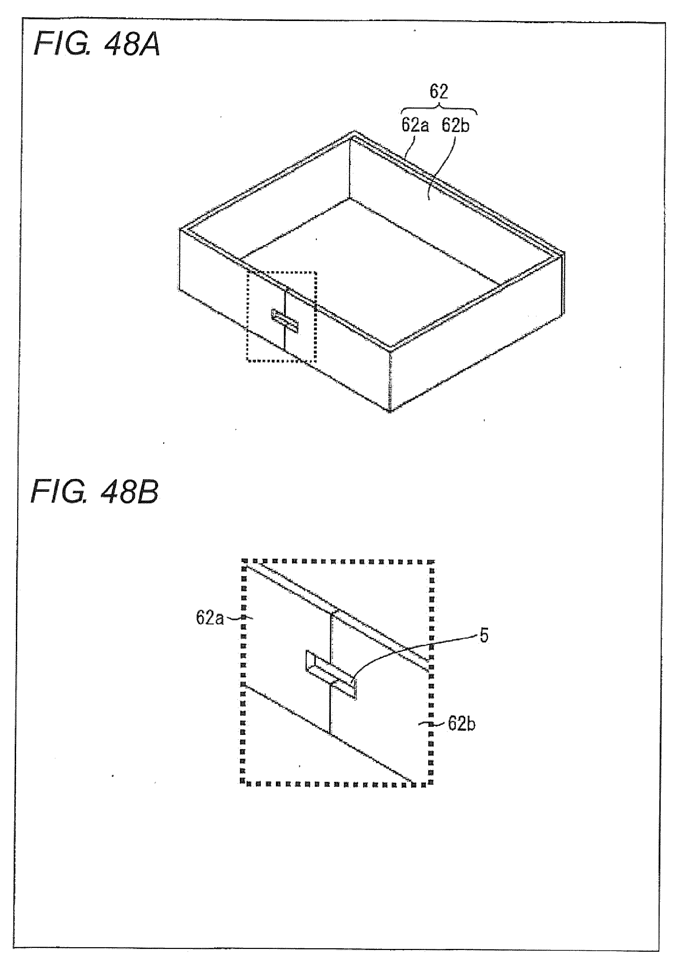

Under such conditions, results of measurement by means of the magnetic cores in the respective figures were 0.018 mT in the magnetic core of FIG.7A, 0.0015 mT in the magnetic core of FIG.7B, 0.046 mT in the magnetic core of FIG. 7C, 0.073 mT in the magnetic core of FIG. 7D, and 0.073 mT in the magnetic core of FIG. 7E. That is, the magnetic cores 1 of FIGS. 7D and 7E realize measurement sensitivity which is four times as high as that of the magnetic core of FIG. 7A, 48 times as high as that of the magnetic core of FIG. 7B, and about 1.6 times as high as that of the magnetic core of FIG. 7C. It is found also from the above that the magnetic core 1 has significantly improved measurement sensitivity for a magnetic flux density as compared with the known magnetic core.

In addition, the measurement results described here and measurement results that will be described using later-mentioned figures are both results obtained by means of simulation. Since there is almost no difference recognized between an actual value and a simulated value, simulation is considered as appropriate in checking a variety of effects of the magnetic core 1 and the like with respect to the conventional magnetic core.

### [2-2 Mechanism of improvement in sensitivity]

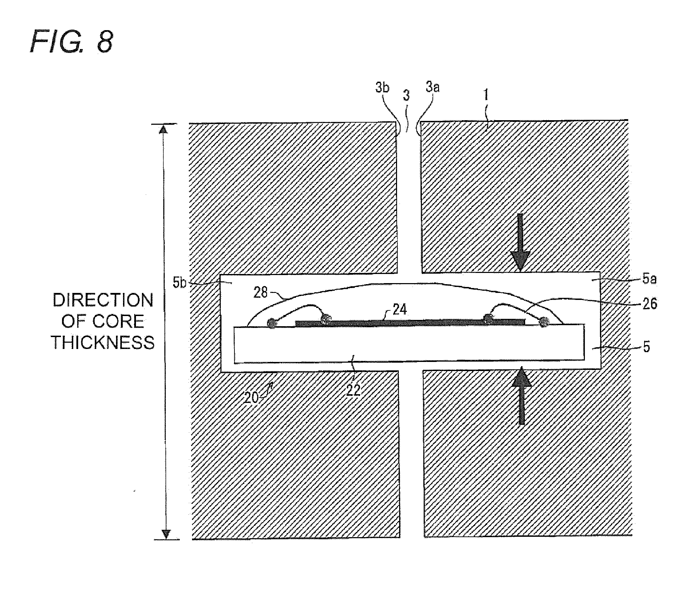

As described above, the magnetic core 1 has significantly improved measurement sensitivity for a magnetic flux density as compared with the known magnetic core. The reason for this will be described by means of FIG. 8. FIG. 8 is a view for explaining improvement in measurement sensitivity for a magnetic flux density by means of the magnetic core 1, as well as a view showing a positional relation of a magnetoelectric conversion element 20 with respect to the magnetic flux leakage section 3.

As shown in the figure, the element holding hole 5 is provided in a vertical direction to the thickness direction of the magnetic core 1, and the magnetoelectric conversion element 20 is held in the element holding hole 5.

The magnetoelectric conversion element 20 primarily has a substrate 22, a sensor film 24, a wire bonding 26, and a mold agent 28. The sensor film 24 is arranged on the plate-like substrate 22, and the substrate 22 and the sensor film 24 are fixed by the wire bonding 26. Then, the substrate 22, the sensor film 24 and the wire bonding 26 are coated by the mold agent 28. The magnetoelectric conversion element 20 is held in the element holding hole 5 so as to cross the magnetic flux leakage section 3.

In the magnetic core 1, the positional relation of a magnetoelectric conversion element 20 with respect to the magnetic flux leakage section 3 is set. Accordingly, a magnetic flux is prone to leakage from the magnetic core 1 to the element holding hole 5 through the magnetic flux leakage section 3, and the magnetoelectric conversion element 20 held in the element holding hole 5 can sense leakage of the magnetic flux from the vertical direction (thickness direction of the magnetic core 1).

Further, the sensitivity of the magnetic core is more favorable when the magnetic flux leakage section 3 has magnetic resistance being low to some degree. Then, with a smaller width of the magnetic flux leakage section 3 (distance between the first open end plane 3a and the second open end plane 3b), the magnetic resistance of the magnetic flux leakage section 3 decreases. In this respect, in the magnetic core 1, the magnetoelectric conversion element 20 is held in the first element holding hole 5a and the second element holding hole 5b which are formed on the first open end plane 3a and the second open end plane 3b. Therefore, it is not necessary to make large the distance between the first open end plane 3a and the second open end plane 3b to such a degree that the magnetoelectric conversion element 20 can be held therebetween. That is, due to the presence of the element holding hole 5, it is possible to make small the distance between the first open end plane 3a and the second open end plane 3b without consideration of the size of the magnetoelectric conversion element 20. Accordingly, in the magnetic core 1, the magnetic flux leakage section 3 has a small width and thus causes magnetic resistance of the magnetic flux leakage section 3 to decrease.

For such a reason, the magnetic core 1 has significantly improved measurement sensitivity for a magnetic flux density as compared with the known magnetic core.

It is to be noted that, when the magnetic flux leakage section is not present in the magnetic core, a difference in magnetic resistance between the magnetic core and the element holding hole becomes excessively large (on the order of 10⁴ times), and a magnetic flux hardly leaks to the element holding hole and the magnetoelectric conversion element does not sense the magnetic flux.

Further, for the magnetoelectric conversion element 20, there can be used a MR (magneto-resistive) element such as GMR (Giant Magneto-Resistance), AMR (Anisotropic Magnetoresistive), a MI (magneto-impedance) element, a flux gate element, a Hall element or the like.

Further, in FIG. 8, it has been described as assuming that the element holding hole 5 is provided in a vertical direction to the thickness direction of the magnetic core 1. However, even when the element holding hole 5 is provided in the vertical direction to the width direction of the magnetic core 1 (vertical direction to the thickness direction of the magnetic core 1) and the magnetoelectric conversion element 20 is held in that element holding hole 5, a similar effect to the above can be exerted.

### [2-3 Data (2) on improvement in sensitivity]

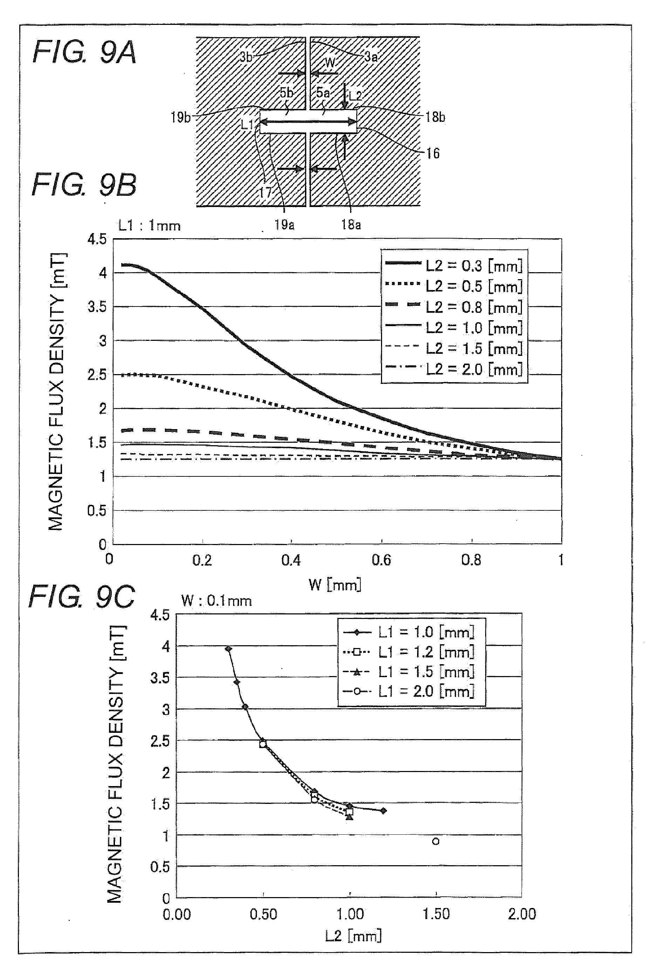

Further, it will be described using FIG. 9 that the measurement sensitivity for a magnetic flux density by means of the magnetic core 1 is influenced by the width of the magnetic flux leakage section 3 (distance between the first open end plane 3a and the second open end plane 3b), a size of the element holding hole 5, or the like. FIG. 9 is a view showing results of measurement of a magnetic flux density by means of the magnetic core 1, where FIG. 9A is a view for showing a definition of each symbol, FIG. 9B is a graph showing a magnetic flux density at the time of changing L2, and FIG. 9C is a graph showing a magnetic flux density at the time of changing L1;

First, a definition of each of later-described symbols will be described using FIG. 9A. In addition, FIG. 9A may be considered as corresponding to a view with the magnetoelectric conversion element 20 deleted from FIG. 8.

As shown in FIG. 9, symbol W represents the width of the magnetic flux leakage section 3 (distance between the first open end plane 3a and the second open end plane 3b).

When a side surface opposed to a side surface forming the second element holding hole 5b among side surfaces forming the first element holding hole 5a is regarded as a side surface (first side surface) 16 and a side surface opposed to the side surface 16 among side surfaces forming the second element holding hole 5b is regarded as a side surface (second side surface) 17, symbol L1 represents a distance between the side surface 16 and the side surface 17.

When side surfaces except for the side surface 16 among the side surfaces forming the first element holding hole 5a are regarded as side surface 18a and side surface 18b, symbol L2 represents a distance between the side surface 18a and the side surface 18b. In addition, when side surfaces except for the side surface 17 among the side surfaces forming the second element holding hole 5b are regarded as side surface 19a and side surface 19b, symbol L2 also is a distance between the side surface 19a and the side surface 19b.

As thus described, W, L1 and L2 are defined. Next, measurement results of FIG. 9B will be described. FIG. 9B shows a magnetic flux density when L2 is changed to 0.3 mm, 0.5 mm, 0.8 mm, 1.0 mm, 1.5 mm and 2.0 mm and W is changed in the range of 0 to 1 mm while L1 is fixed to 1 mm.

At this time, it is found as shown in FIG. 9B that, with smaller L2, the measured magnetic flux density increases, namely the measurement sensitivity improves. Accordingly, the following can be said. That is, the first element holding hole 5a and the second element holding hole 5b preferably hold the magnetoelectric conversion element 20 such that a magnetic sensing direction of the magnetoelectric conversion element 20 is a circumferential direction of the magnetic core 1. It is thus possible to align the magnetoelectric conversion element 20 having a small size in the thickness direction of the magnetoelectric conversion element 20 to a direction from the side surface 18a toward the side surface 18b (or direction from the side surface 19a toward the side surface 19b) corresponding to the vertical direction in the figure, thereby to make L2 small. That is, the thickness direction of the magnetoelectric conversion element 20 is smaller than the longitudinal direction thereof. Therefore, aligning the thickness direction from the side surface 18a toward the side surface 18b (or direction from the side surface 19a toward the side surface 19b), which corresponds to the vertical direction in the figure, can make L2 small. This can result in improvement in measurement sensitivity of the magnetic core 1.

Further, as shown in FIG. 9B, with smaller W, the measured magnetic flux density increases, namely the measurement sensitivity improves. Therefore in the magnetic core 1, making W small can improve the measurement sensitivity of the current sensor using the magnetic core 1.

Next, FIG. 9C will be described. FIG. 9C shows a magnetic flux density when L1 is changed to 1.0 mm, 1.2 mm, 1.5 mm and 2.0 mm and L2 is changed in the range of 0 to 1.5 mm while W is fixed to 0.1 mm.

At this time, it is found as shown in FIG. 9C that, with smaller L2, the measured magnetic flux density increases, namely the measurement sensitivity improves. Also from this, for a similar reason to the above, the first element holding hole 5a and the second element holding hole 5b preferably hold the magnetoelectric conversion element 20 such that a magnetic sensing direction of the magnetoelectric conversion element 20 is the circumferential direction of the magnetic core 1.

It is to be noted that, with smaller W at the time of L1 being changed to 1.0 mm, 1.2 mm, 1.5 mm and 2.0 mm, the measured magnetic flux density increases, namely the measurement sensitivity improves. However, due to the difference being slight, a significant effect exerted by changing L1 was not recognized.

### [2-4 Data (3) on abutting structure]

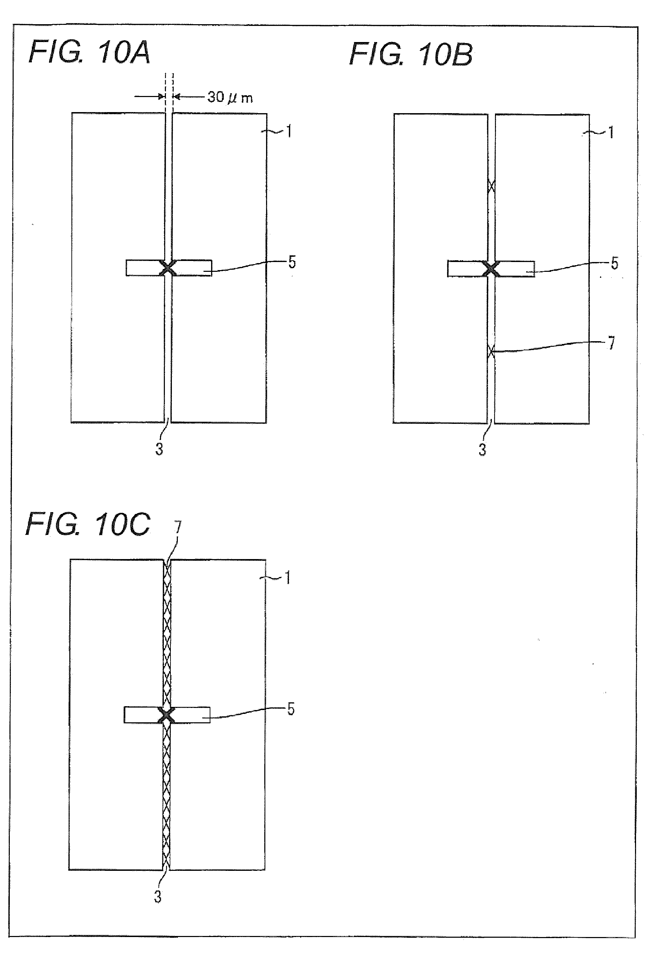

As described above, the magnetic core 1 may have the abutting structure for the reason in terms of manufacturing and processing, the magnetic core 1 may have the abutting structure. Also in this case, the magnetic core 1 has a similar effect to the case of the gap structure. This will be described using FIG. 10.

FIG. 10 is a view showing the magnetic cores 1 having the gap structure and the abutting structure, where FIG. 10A is a view showing the magnetic core 1 having the gap structure, FIG. 10B is a view showing the magnetic core 1 having the abutting structure in which the first open end plane 3a and the second open end plane 3b are in contact with each other at two points, and FIG. 10C is a view showing the magnetic core 1 having the abutting structure in which the first open end plane 3a and the second open end plane 3b are in contact with each other at 16 points.

It is to be noted that in any magnetic core 1, the width of the magnetic flux leakage section 3 is kept to be 30 µm. Further, in FIGS. 9B and 9C, a point at which the first open end plane 3a and the second open end plane 3b are in contact with each other is referred to as a contact point 7.

Further, a contact area of the contact point 7 is set to 3 µm² which is sufficiently smaller than a cross section of the first open end plane 3a or the second open end plane 3b. This reflects the fact that the contact area of the contact point 7 is sufficiently smaller than a cross section of the first open end plane 3a or the second open end plane 3b at the time of actually manufacturing and processing a magnetic core having the abutting structure.

Under such conditions, results of measurement of the magnetic flux density by means of the magnetic cores 1 in the respective figures were all 2.5 mT. It can be said from this that the measurement sensitivity of the magnetic core 1 remains unchanged even when the core has the gap structure. Therefore, in a case where it is practically difficult to manufacture and process the magnetic core without any contact between the first open end plane 3a and the second open end plane 3b, the magnetic core can be used while keeping the gap structure. Accordingly, it is possible to realize the magnetic core 1 capable of further enhancing the detection sensitivity of the current sensor, while also eliminating the need for additional step in the manufacturing and processing and realizing low cost.

### [2-5 Data on size of element holding hole 5 and width of magnetic flux leakage section 3]

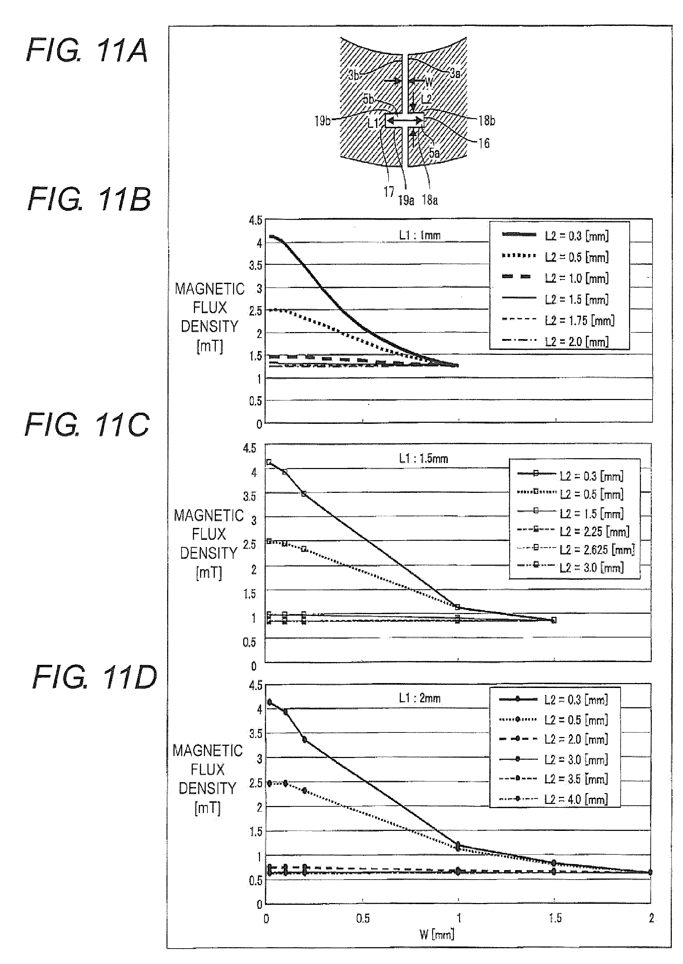

Further, influences exerted by the size (L1, L2) of the element holding hole 5 and the width (W) of the magnetic flux leakage section 3 on a measurement result will be described using FIG. 11. FIG. 11 is a view showing results of measurement of a magnetic flux density by means of the magnetic core 1, where FIG. 11A is a view for showing a definition of each symbol, FIG. 11B is a graph showing a magnetic flux density at the time of setting L1 to 1 mm, FIG. 11C is a graph showing a magnetic flux density at the time of setting L1 to 1.5 mm, and FIG. 11D is a graph showing a magnetic flux density at the time of setting L1 to 2 mm. In addition, FIG. 11 is a graphic plot of Table 1 below.

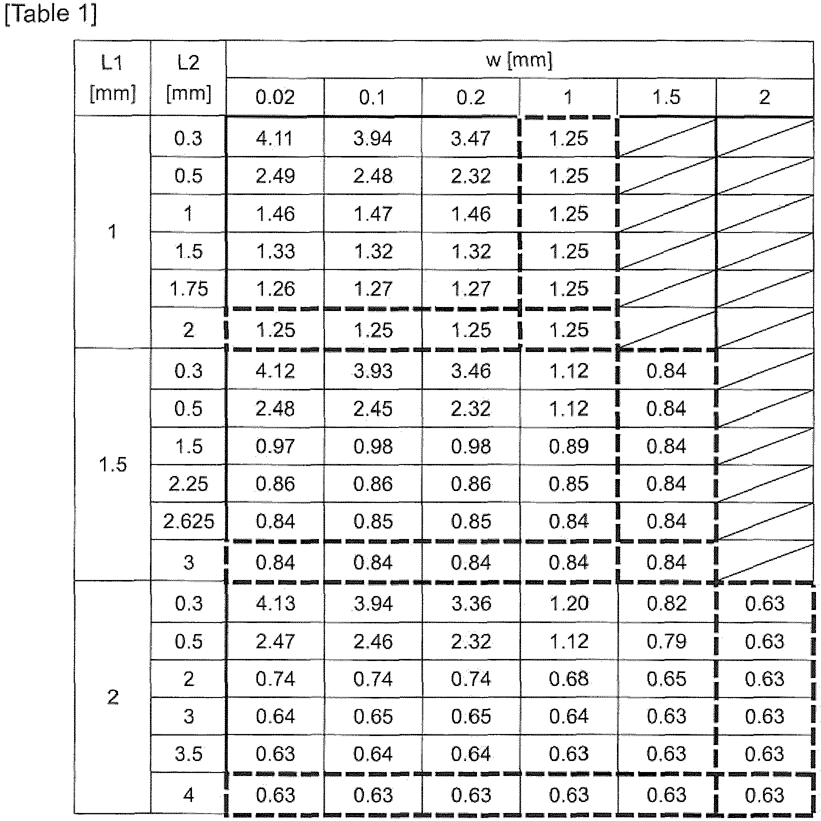

The following can be said as considerations obtained from Table 1 and FIG. 11.

First, in any of cases of L1 = 1 mm, 1.5 mm and 2 mm, when L2 is more than 1.75 times as large as L1, the magnetic flux density remains unchanged regardless of the width (W) of the magnetic flux leakage section 3. For example, when L1 is set to 1 mm and L2 = 1.75, the magnetic flux density is 1.26 mT in the case of W = 0.02 mm, the magnetic flux density is 1.27 mT in the case of W = 0.1 mm and 0.2 mm, and the magnetic flux density is 1.25 mT in the case of W=1 mm. Therefore, a slight change in magnetic flux density is recognized. However, when L2 = 2 mm, all the magnetic flux densities are 1.25 mT regardless of the value of W. It can also applies to the cases of L1 = 1.5 mm and 2 mm. That is, when L2 is more than 1.75 times as large as L1, the magnetic flux density remains unchanged regardless of the width (W) of the magnetic flux leakage section 3, whereby L2 is required to be not more than 1.75 times as large as L1 in the magnetic core 1.

Further, when L1 becomes the same as W, values of the magnetic flux density converge to a fixed value regardless of the value of L2. This requires L1 > W in the magnetic core 1.

### [2-6 filling magnetic flux leakage section 3 with magnetic agent having lower permeability than magnetic core 1]

In [2-2 Mechanism of improvement in sensitivity] above, it was described that the sensitivity of the magnetic core is more favorable when the magnetic flux leakage section 3 has magnetic resistance being low to some degree, and for that purpose, the magnetic resistance of the magnetic flux leakage section 3 decreases with a smaller width (W) of the magnetic flux leakage section 3. Herein, another method for lowering the magnetic resistance of the magnetic flux leakage section 3 will be described by means of FIG. 12.

FIG. 12 is a view for explaining that the sensitivity of measurement of a magnetic flux density by means of the magnetic core 1 is influenced by the presence or absence of a magnetic agent (low permeability material), wherein FIG. 12A is a view showing the case of neither the magnetic flux leakage section 3 nor the element holding hole 5 being filled with the magnetic agent, FIG. 12B is a view showing the case of only the magnetic flux leakage section 3 being filled with the magnetic agent, FIG. 12C is a view showing the case of only the element holding hole 5 being filled with the magnetic agent, and FIG. 12D is a view showing the case of both the magnetic flux leakage section 3 and the element holding hole 5 being filled with the magnetic agent.

It is to be noted that the magnetic agent has a relative permeability of 20, and is a material having a low relative permeability than the magnetic core 1 body. Further, a mark x shown in each figure indicates a measurement point of a magnetic flux density.

Under such conditions, results of measurement by means of the magnetic cores in the respective figures were 2.44 mT in the magnetic core 1 of FIG. 12A, 2.90 mT in the magnetic core 1 of FIG.12B, 48.68 mT in the magnetic core 1 of FIG. 12C, and 48.14 mT in the magnetic core 1 of FIG. 12D. It was found from the above that especially by filling of the element holding hole 5 with the magnetic agent, the measurement sensitivity for a magnetic flux density significantly improves. Further, it was also found that when the element holding hole 5 is filled with the magnetic agent, the sensitivity improve with the same magnification as a relative permeability of the magnetic agent.

It was thus shown that by filling of the element holding hole 5 (or the magnetic flux leakage section 3 and the element holding hole 5) with a material having a lower relative permeability than the magnetic core, the magnetic resistance of the magnetic flux leakage section 3 is lowered, thereby to improve the sensitivity of the magnetic core 1.

In addition, as such a magnetic agent (material), the ferrite-containing epoxy resin, the magnetic fluid, the air or the like can be employed.

### [2-7 About noise resistance]

Next, it will be described that noise resistance is improved by the magnetic core 1. FIG. 13 is a view showing results of measurement of a magnetic flux density by means of a known magnetic core and the magnetic core 1, where FIG. 13A is a view showing a result of measurement by means of a known magnetic core of FIG. 17A, FIG. 13B is a view showing a result of measurement by means of a known magnetic core of FIG. 17B, FIG. 13C is a view showing a result of measurement by means of a magnetic core obtained by further providing a void section (corresponding to the magnetic flux leakage section 3 of the present embodiment) in the magnetic core of FIG. 13B, and FIG. 13D is a view showing a result of measurement by means of the magnetic core 1.

In addition, in each figure, symbol P denotes a measuring object wire and symbol Q denotes an external wire, and a distance between P and Q is set to 20 mm. Further, as a method for determining the noise resistance, a current of 30 mA is allowed to flow through the measuring object wire P and a magnetic flux density at that time is measured. Further, in order to have an influence as an external magnetic field, a current of 20 A is allowed to flow through the external wire Q while a current of 30 mA is allowed to flow through the measuring object wire P, and a magnetic flux density at that time is measured. On that basis, it is calculated as to how much measurement error occurs between the measured two magnetic flux densities. It is then determined that the noise resistance is higher with the smaller measurement error and the noise resistance is lower with the larger measurement error.

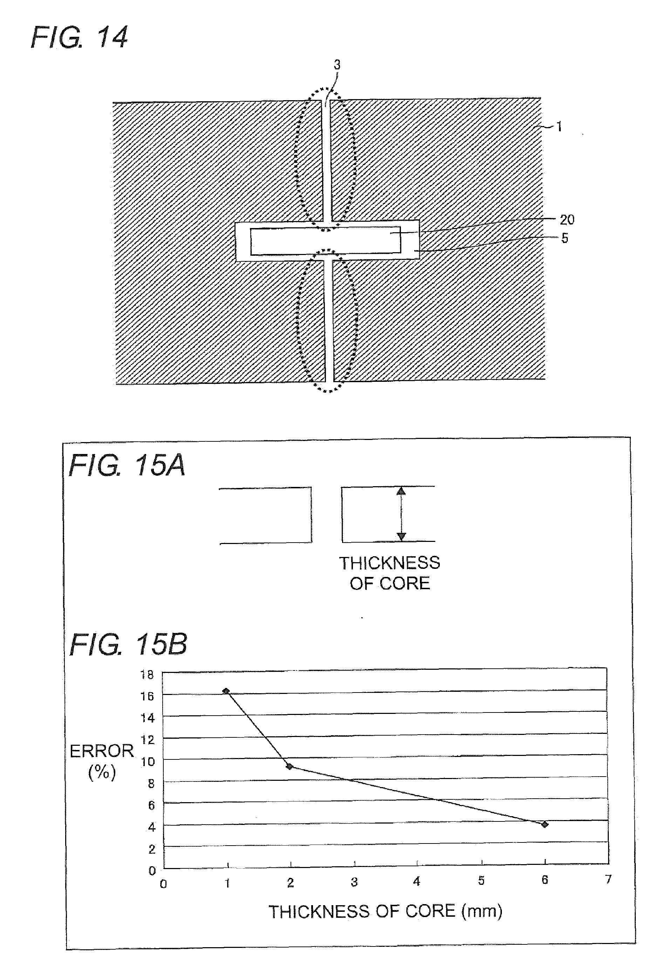

Under such conditions, errors of measurement by means of the magnetic cores in the respective figures were 11.3% in the magnetic core of FIG. 13A, 52% in the magnetic core of FIG. 13B, 73% in the magnetic core of FIG. 13C, and 8.4% in the magnetic core of FIG.13D. It is found also from the above that the magnetic core 1 has high noise resistance as compared with the known magnetic core. The reason for that will be described using FIG. 14. FIG. 14 is a view for explaining that the noise resistance of the magnetic core 1 according to the present invention is high.

In the first place, there has been a problem with the conventional current sensor in that, since the magnetic core itself does not have noise resistance, the current sensor is influenced by an external magnetic field at the time of measuring a current of several tens of mA and a value to be detected is buried in noise.

In this regard, in the magnetic core 1, it is considered that the magnetic flux leakage section 3 surrounded by a broken line in the figure serves as a shield against an external magnetic field that is generated due to the earth's magnetism, an external current or the like, and by the shield effect, an influence exerted by the external magnetic field on the magnetoelectric conversion element 20 held in the element holding hole 5 is reduced.

Further, by the magnetic flux leakage section 3 serving as the shield, it is also possible to solve the problem of the prior art, namely the problem that covering the magnetic core with the shield member interferes with reduction in size and cost.

Next, an influence exerted by a thickness of the magnetic core on the noise resistance will be described in FIG. 15. FIG. 15 is a graph showing the relation between the thickness of the magnetic core and the measurement error.

In the graph shown in the figure, a lateral axis indicates the thickness (mm) of the magnetic core, and a longitudinal axis indicates the measurement error (%). It should be noted that measurement conditions are the same as the conditions described with reference to FIG. 13D.

As shown in the figure, with a larger width of the magnetic core, the measurement error decreases. That is, with a larger width of the magnetic core, the noise resistance improves. This is attributed to that the magnetic flux leakage section 3 increases with a larger thickness of the magnetic core, accompanied by an increase in shield effect of the magnetic flux leakage section 3. Therefore, by appropriate adjustment of the thickness of the magnetic core, it is possible to realize both reduction in size and improvement in measurement accuracy of the current sensor.

### [3. Effect obtained by magnetic core 1]

Hereinafter, an effect obtained by the magnetic core 1 will be described.

With reference to FIG. 1C and the like, the magnetic core 1 is a magnetic core used for the current sensor, having: the first open end plane 3a which is formed with the first element holding hole 5a for holding the magnetoelectric conversion element 20; and the second open end plane 3b which is formed with the second element holding hole 5b for holding the magnetoelectric conversion element 20, and is opposed to the first open end plane 3a.

The magnetic core 1 has the first open end plane 3a and the second open end plane 3b which are opposed to each other. Then, the first element holding hole 5a is formed on the first open end plane 3a, the second element holding hole 5b is formed on the second open end plane 3b, and the magnetoelectric conversion element 20 is held in the first element holding hole 5a and the second element holding hole 5b.

Therefore, due to the presence of the first open end plane 3a and the second open end plane 3b, namely the presence of a void section (hereinafter referred to as a "magnetic flux leakage section 3") between the first open end plane 3a and the second open end plane 3b, a magnetic flux is prone to leakage from the magnetic core 1 toward the first element holding hole 5a and the second element holding hole 5b, and the magnetoelectric conversion element 20 held in the first element holding hole 5a and the second element holding hole 5b can sense the leakage of the magnetic flux.

In addition, while the sensitivity of the magnetic core is more favorable with lower magnetic resistance of the magnetic flux leakage section 3, the magnetic resistance of the magnetic flux leakage section 3 is lower with a smaller width of the magnetic flux leakage section 3 (distance between the first open end plane 3a and the second open end plane 3b). In this respect, in the magnetic core 1, the magnetoelectric conversion element 20 is held in the first element holding hole 5a and the second element holding hole 5b which are formed on the first open end plane 3a and the second open end plane 3b. Therefore, it is not necessary to make large the distance between the first open end plane 3a and the second open end plane 3 to such a degree that the magnetoelectric conversion element 20 is held therebetween. That is, due to the presence of the element holding hole 5, it is possible to make small the distance between the first open end plane 3a and the second open end plane 3 without consideration of a space for the magnetoelectric conversion element 20 to be placed. Accordingly, in the magnetic core 1, the magnetic flux leakage section 3 has a small width and thus causes magnetic resistance of the magnetic flux leakage section 3 decrease, thereby allowing improvement in sensitivity of the current sensor that uses the magnetic core 1.

For such a reason, the magnetic core 1 can solve the conventional problem described with reference to FIG. 17A (problem that the width of the cut-off section has to be made large for providing the magnetoelectric conversion element 20 in the cut-off section, accompanied by deterioration in sensitivity of the magnetic core 1).

Further, in the magnetic core 1, the first element holding hole 5a and the second element holding hole 5b are formed not in positions along an outer edge of the magnetic core 1 where a magnetic flux is resistant to leakage from the magnetic core 1, but on the first open end plane 3a and the second open end plane 3b. For the above reason, in the magnetic core 1, the magnetoelectric conversion element 20 is held in the first element holding hole 5a and the second element holding hole 5b where a magnetic flux is prone to leakage from the magnetic core 1, whereby it is possible to collect a larger amount of magnetic flux generated due to a minute current, so as to improve the sensitivity.

Therefore, the magnetic core 1 can solve the conventional problem described with reference to FIG. 17B (problem that, due to placement of the magnetoelectric conversion element 20 in the notch section formed along the outer edge of the magnetic core, a magnetic flux is resistant to leakage from the magnetic core and the magnetoelectric conversion element 20 detects a minute magnetic flux, thereby to cause deterioration in sensitivity of the magnetic core).

As thus described, with the above configuration formed, a magnetic core capable of enhancing the detection sensitivity of the current sensor can be realized as the magnetic core 1.

In addition, the magnetic core 1 also exerts such an effect as follows.

That is, the conventional current sensor is influenced by an external magnetic field at the time of measuring a current of several tens of mA since the magnetic core itself does not have a structure (function) to realize noise resistance, and hence the current sensor cannot perform current measurement with high detection sensitivity.

However, in the magnetic core 1, the magnetic flux leakage section 3 serves as a shield against an external magnetic field that is generated due to the earth's magnetism, an external current or the like. Hence the magnetic core 1 can even solve the conventional problem that covering the magnetic core with the shield member interferes with reduction in size and cost.

Further, with reference to FIGS. 9A to 9C and the like, the magnetic core 1 may be configured that the magnetoelectric conversion element 20 is held in the first element holding hole 5a and the second element holding hole 5b such that a magnetic sensing direction of the magnetoelectric conversion element 20 is a circumferential direction of the magnetic core 1.

With the above configuration formed, it is possible to select a magnetoelectric conversion element 20 with a small size in the thickness direction of the magnetoelectric conversion element 20 (thickness direction of the magnetic core 1 which is vertical to the circumferential direction of the magnetic core 1), so as to make small widths of the first element holding hole 5a and the second element holding hole 5b, which hold the magnetoelectric conversion element 20, in the thickness direction of the magnetic core. With smaller widths of the first element holding hole 5a and the second element holding hole 5b in the thickness direction of the magnetic core 1, a magnetic flux that leaks from the magnetic core 1 is amplified, and hence with the above configuration formed, it is possible to enhance the sensitivity of the magnetoelectric conversion element 20. Accordingly, a magnetic core capable of further enhancing the detection sensitivity of the current sensor can be realized as the magnetic core 1.

Further, with reference to FIG. 12 and the like, the magnetic core 1 may be configured that the first element holding hole 5a and the second element holding hole 5b are filled with a low permeability material having a lower permeability than the magnetic core 1.

Filling the first element holding hole 5a and the second element holding hole 5b with the low permeability material allows improvement in sensitivity with the same magnification as a relative permeability of the low permeability maternal.

Accordingly, with the above configuration formed, it is possible to realize a magnetic core capable of further enhancing the detection sensitivity of the current sensor.

Further, with reference to FIG. 12 and the like, the magnetic core 1 may be configured that a space between the first open end plane 3a and the second open end plane 3b is filled with a low permeability material having a lower permeability than the magnetic core 1.

With a lower value of magnetic resistance between the first open end plane 3a and the second open end plane 3b, the sensitivity of the entire magnetic core becomes higher. Accordingly, with the above configuration formed, it is possible to realize a magnetic core capable of further enhancing the detection sensitivity of the current sensor.

Further, in the magnetic core 1, the low permeability material may be the ferrite-containing epoxy resin, the magnetic fluid or the air.

As typical magnetic core materials, PB permalloy, PC permalloy, amorphous, a silicon steel plate and the like are known. Any material can be used for the magnetic core 1. Examples of the low permeability material having a lower permeability than the magnetic core may include the ferrite-containing epoxy resin, the magnetic fluid and the air.

Therefore, filling the first element holding hole 5a and the second element holding hole 5b with the ferrite-containing epoxy resin, the magnetic fluid or the air leads to realization of a magnetic core capable of further enhancing the detection sensitivity of the current sensor.

Further, with reference to FIG. 11 and the like, in the magnetic core 1, when a side surface opposed to a side surface forming the second element holding hole 5b among side surfaces forming the first element holding hole 5a is regarded as a first side surface and a side surface opposed to the first side surface among side surfaces forming the second element holding hole 5b is regarded as a second side surface, the first element holding hole 5a and the second element holding hole 5b preferably have hole widths in the thickness direction of the held magnetoelectric conversion element 20 not more than 1.75 times as large as the distance between the first side surface and the second side surface.

It was found that, regardless of the distance between the first open end plane 3a and the second open end plane 3b, when the hole width is more than 1.75 times as large as the distance between the side surfaces, the effect of making small the distance between the first open end plane and the second open end plane is lost.

Accordingly, with the above configuration formed, such an effect is exerted that a large amount of magnetic flux is collected in the magnetoelectric conversion element 20 even with a minute current.

Further, in the magnetic core 1, the distance between the first open end plane 3a and the second open end plane 3 is preferably smaller than 2 mm.

In light of a size of a typical magnetoelectric conversion element 20, when the distance between the first open end plane 3a and the second open end plane 3b is not smaller than 2mm, there is a space where the magnetoelectric conversion element 20 can be arranged even without the presence of the first element holding hole 5a and the second element holding hole 5b.

Thereat, with the above configuration formed, such an effect is exerted that the magnetoelectric conversion element 20 can be held in the first element holding hole 5a and the second element holding hole 5b even when the distance between the first open end plane 3a and the second open end plane 3b is smaller than 2 mm, and the magnetoelectric conversion element 20 can reliably sense a magnetic flux leaking from the magnetic core 1 to the first element holding hole 5a and the second element holding hole 5b.

Further, with reference to FIG. 10 and the like, the magnetic core 1 may be configured that parts of the first open end plane 3a and the second open end plane 3b are in contact with each other.

As the structure of a typical magnetic core, there are known a variety of types such as an integrated type, a laminated type and a docked type, and the magnetic core 1 is adoptable to any type. However, there are cases where it is practically difficult to manufacture and process the magnetic core of any type without any contact between the first open end plane 3a and the second open end plane 3b.

In this regard, in the magnetic core according to the present invention, even when parts of the first open end plane 3a and the second open end plane 3b are in contact with each other, since a magnetic flux leaks from the magnetic core 1 to the first element holding hole 5a and the second element holding hole 5b through the magnetic flux leakage section 3, the magnetoelectric conversion element 20 can sense the leakage of the magnetic flux. Therefore, in a case where it is difficult to perform manufacturing and processing without any contact between the first open end plane 3a and the second open end plane 3b, the magnetic core can be used as it is. Accordingly, it is possible to realize a magnetic core capable of further enhancing the detection sensitivity of the current sensor, while also eliminating the need for additional step in the manufacturing and processing and realizing low cost.

With reference to FIG. 3 and the like, the first element holding hole 5a and the second element holding hole 5b are respectively extended on the first open end plane 3a and the second open end plane 3b along a parallel direction to the thickness direction of the magnetic core 1.

Further, with reference to FIG. 2 and the like, the magnetic core 1 may be configured that first element holding hole 5a and the second element holding hole 5b are respectively extended on the first open end plane 3a and the second open end plane 3b along a vertical direction to the thickness direction of the magnetic core 1.

As described above, as the structure of the typical magnetic core, there are known a variety of types such as the integrated type, the laminated type and the docked type.

Therefore, for example when a stacked magnetic core is to be produced, a plurality of layers formed with the first element holding hole 5a and the second element holding hole 5b in the same place are prepared, and those layers are sequentially stacked so that the magnetic core 1 can be manufactured with ease at low cost. Also when the magnetic core 1 of the integrated type or the docked type is to be produced, with the above configuration formed, the magnetic core 1 can be manufactured with ease at low cost. This can realize the magnetic core 1 suitable for mass production.

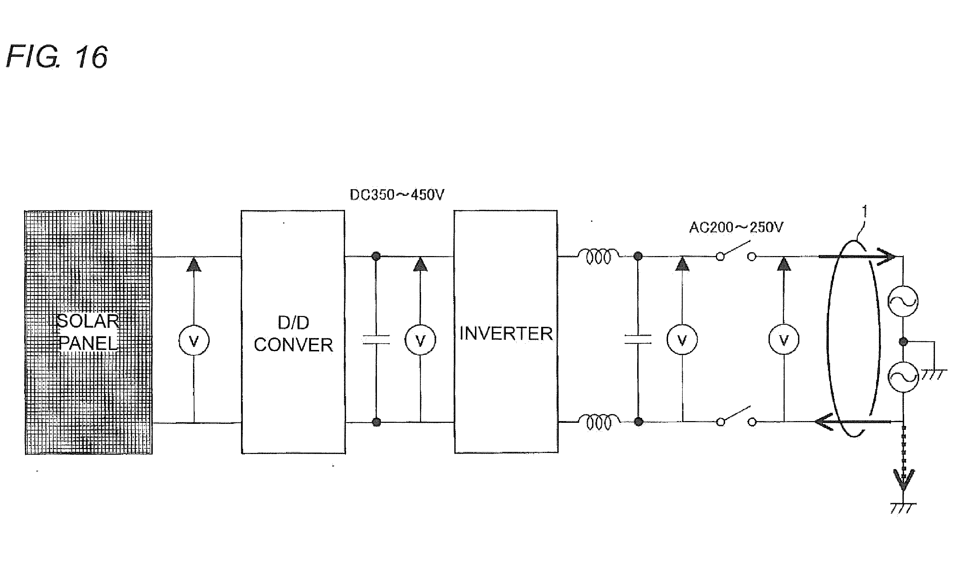

Further, with reference to FIG. 16 and the like, the current sensor according to the present invention is preferably configured to be provided with the magnetic sensor 1.

With the above configuration formed, it is possible to realize a current sensor capable of performing high sensitive measurement.

Moreover, the current measuring method according to the present invention is preferably measuring a current value of a current flowing through a measuring object wire by a current sensor provided with the magnetic core 1.

With the above configuration formed, it is possible to realize a current measuring method capable of performing high sensitive measurement.

### [4. One case of application of magnetic core 1]

The current sensor provided with the magnetic core 1 is applicable to a variety of usages, such as leakage detection for a power conditioner that is a solar cell, a fuel cell or the like, monitoring of a battery loaded in a hybrid car, a plug-in hybrid car or the like, and monitoring of a battery of a data center UPS.

Threat, one case of application of the magnetic core 1 will be described by means of FIG. 16. FIG. 16 is a view at the time of applying the current sensor provided with the magnetic core 1 to leakage detection of a power conditioner for a solar cell.

As shown in the figure, an alternate current outputted from the solar panel is rectified in a converter, and converted to a direct current in an inverter. Then, the magnetic core 1 amplifies a magnetic field generated from currents of two measuring object wires which are indicated by arrows in the figure.

Herein, the currents in the two measuring object wires correspond to forward and backward currents, and a total current value is 0 A. Therefore, when leakage has occurred, the total current value is not 0 A. Therefore, the applying the current sensor provided with the magnetic core 1 can detect the occurrence or non-occurrence of leakage by measuring a total current value.

It is to be noted that in FIG. 16, two wires which are the forward and backward wires are measured as the measuring object wires. However, the magnetic core 1 and the current sensor provided with the magnetic core 1 can naturally perform current detection on one measuring object wire.

Further, in the case shown in the figure, the current leakage sensor provided with the magnetic core 1 measures current values of 30 mA, 50 mA, 100 mA and 150 mA specified by International Standard. However, in the case of application to another usage, the magnetic core 1 can naturally measure a variety of current values.

The description was provided in the above by taking the case of applying the magnetic core 1 to leakage detection of the power conditioner for a solar cell as one application case. However, the example described herein is strictly one application case, and its usage is not restrictive.

### [5. Current sensor provided with magnetic core]

Next, the current sensor 30 provided with the magnetic core 1 will be described by means of FIGS. 18 to 24. It should be noted that, as for the contents described with reference to FIG. 1 and the like, its description will be omitted.

FIG. 18 is an external view of a current sensor 30. The current sensor 30 is formed with its appearance made up of a case 31. The case 31 is provided with a through hole in the vertical direction, and the measuring object wire P is provided in this through hole. The current sensor 30 then detects a magnetic field generated from a current of the measuring object wire P, thereby to measure a current value of a current flowing inside the measuring object wire P.

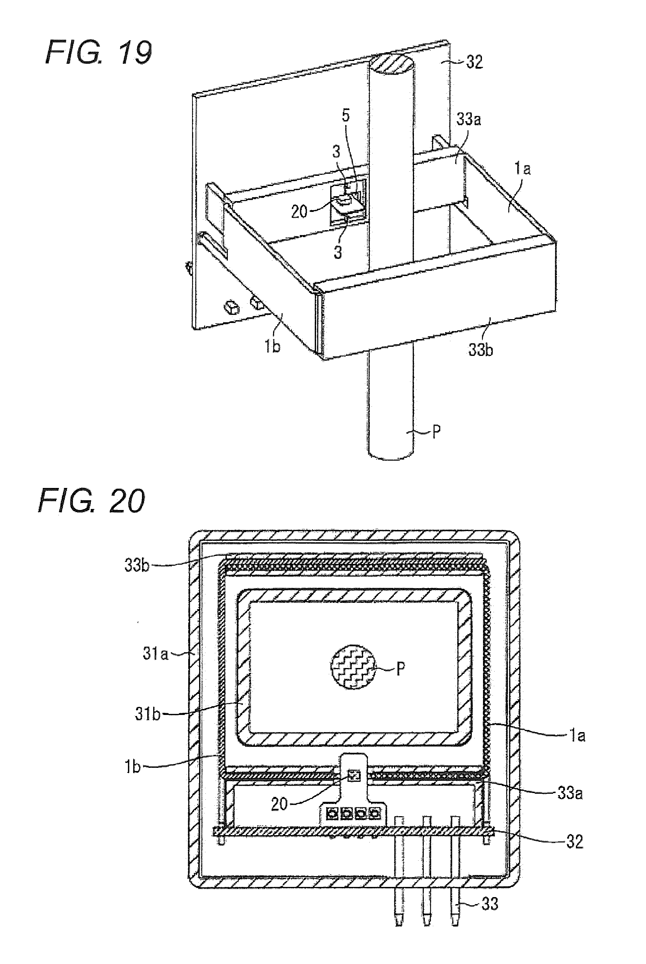

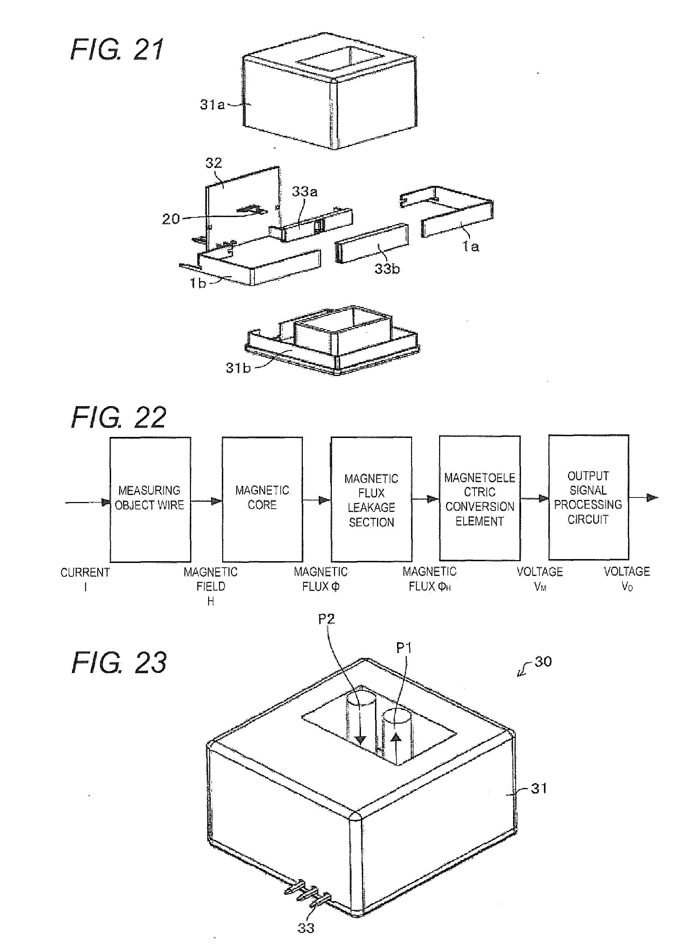

Next, an internal structure of the current sensor 30 will be described by means of FIGS. 19 to 21. FIG. 19 is a perspective view of the internal structure of the current sensor 30. FIG. 20 is one sectional view of the internal structure of the current sensor 30 in the horizontal direction of FIG. 19 (right and left direction of the figure). FIG. 21 is an exploded assembly diagram of the current sensor 30.

As shown in FIG. 19, inside the case 31, the current sensor 30 is provided with magnetic cores 1a, 1b, the magnetic flux leakage section 3, the element holding hole 5, the magnetoelectric conversion element 20, the output signal processing circuit 32, two fasteners 33a, 33b. Further, the current sensor 30 is electrically connected to an external apparatus through an input/output terminal 33.

As shown in FIG. 21, the case 31 is formed by engagement of a case 31 a with a case 31 b, and therefore, the case 31 a serves as an outer case, and the case 31 b serves as an inner case. That is, the case 31 a forms the appearance of the current sensor 30, and the case 31 b forms wall surfaces of the through hole on which the measuring object wire P is arranged. Then, as shown in FIG. 20, the magnetic cores 1 a, 1 b, the magnetic flux leakage section 3, the element holding hole 5, the magnetoelectric conversion element 20, the output signal processing circuit 32 and the fasteners 33a, 33b are provided between the case 31 a and the case 31 b.

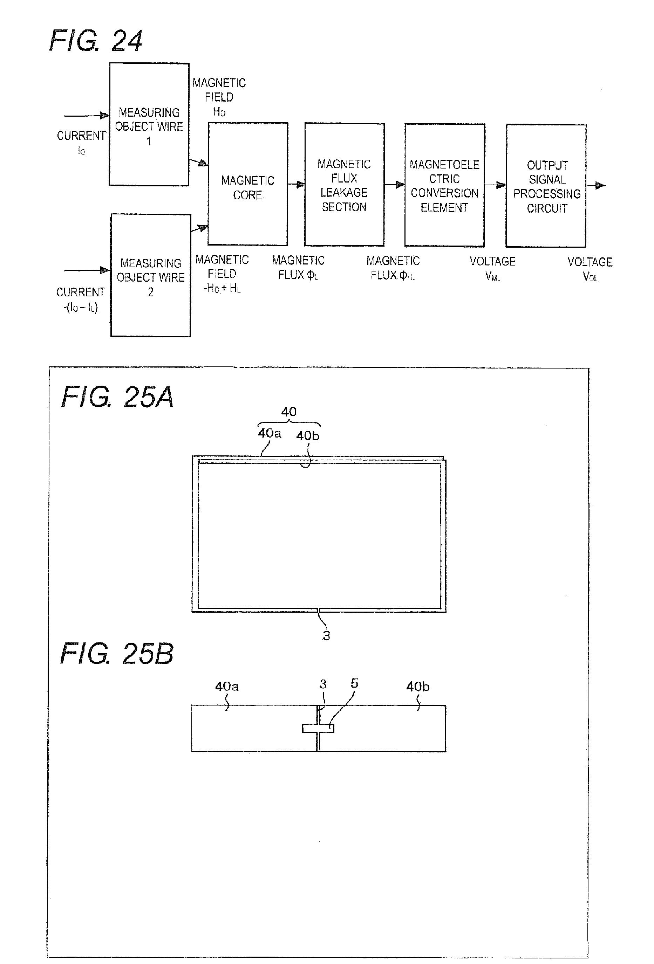

The magnetic core 1 is a docked type that can be divided into two pieces made up with the magnetic core 1 a and a magnetic core 1b (detail will be described with reference to FIGS. 25 and the like). The magnetic core 1a, 1b are held in rectangular shape by being inserted into the fasteners 33a, 33b. Herein, the magnetic flux leakage section 3 and the element holding hole 5 are formed on the fastener 33a side, and the magnetic cores 1 a, 1 b are formed in adhering state on the fastener 33b side. That state is shown in FIGS. 19 and the like.

The fastener 33a functions as a fastener for the magnetic core 1 a and the magnetic core 1b, while being connected to and supported by the plate-like output signal processing circuit 32. The output signal processing circuit 32 is electrically connected to the input/output terminal 33, and processes a voltage outputted from the magnetoelectric conversion element 20, to output a voltage corresponding to a current value of the measuring object wire P to the external apparatus through the input/output terminal 33. A T-shaped small substrate is erected in the output signal processing circuit 32, and the magnetoelectric conversion element 20 is fixed to the small substrate. The magnetoelectric conversion element 20 is positioned so as to be held in the element holding hole 5. That is, in the current sensor 30 in FIGS. 19 to 21, the magnetoelectric conversion element 20 is fixed to the output signal processing circuit 32, and is held inside the element holding hole 5 while being kept in the state of being in non-contact with the element holding hole 5.

It is to be noted that the magnetoelectric conversion element 20 may be held inside the element holding hole 5 while kept in the state of being in contact with the element holding hole 5. Therefore, the magnetoelectric conversion element 20 is realized in a configuration of being held inside the element holding hole 5 while kept in the state of being in contact and/or non-contact with the element holding hole 5.

In addition, the method for holding and fixing the magnetoelectric conversion element is not restricted to the example described here.

Next, an operation of the current sensor 30 measuring a current flowing inside the measuring object wire P will be described by means of FIG. 22. FIG. 22 is a block diagram for explaining the operation of the current sensor 30.

First, a current I flows inside the measuring object P, and a magnetic field H is generated by the current I. Then, a magnetic flux Φ is generated in the magnetic core 1 by the magnetic field H. Next, the magnetic flux Φ generated in the magnetic core 1 leaks into the magnetic flux leakage section 3. Herein, when the magnetic flux having leaked into the magnetic flux leakage section 3 is referred to as a magnetic flux Φ_{H}, the magnetic flux Φ_{H} is detected by the magnetoelectric conversion element 20. The magnetoelectric conversion element 20 converts the detected magnetic flux Φ_{H} to a voltage, and outputs the converted voltage V_{M} to the output signal processing circuit 32. The output signal processing circuit 32 then processes the voltage V_{M}, and outputs a voltage (V_{O}) corresponding to a value of the current flowing in the measuring object wire P to the input/output terminal 33. In this manner, the current sensor 30 measures a current flowing inside the measuring object wire P.

In this manner, the current sensor 30 can measure the current value I of a current flowing inside the measuring object wire P. However, the current sensor 30 can be used not only for measurement of a current value, but also for leakage detection and measurement of a leakage amount, for example. This will be described by means of FIGS. 23, 24.

FIG. 23 is an external view of a current sensor used for leakage detection and measurement of a leakage amount. As shown in the figure, measuring object wires P1, P2 are arranged in the through hole provided in the current sensor 30. Herein, the currents in the two measuring object wires P1, P2 correspond to forward and backward currents, and a total current value is 0 A when there is no leakage. In other words, when leakage has occurred, the total current value is not necessarily 0 A. Through use of this principle, the current sensor 30 detects the occurrence or non-occurrence of leakage, and a leakage amount in the case of occurrence of leakage.

FIG. 24 is a block diagram for explaining the operation of the current sensor in the case of the current sensor being used for leakage detection. By means of this FIG. 24, the operation of the current sensor in the case of the current sensor being used for leakage detection will be described.

First, there will be considered a case where a current I_{O} flows inside the measuring object wire 1 (P1), and a current - (I_{O} - I_{L}) flows inside the measuring object wire 2 (P2), namely a case where a current I_{L} is leaking. At this time, the current I_{O} flows inside the measuring object wire P1, and a magnetic field H_{O} is generated by the current I_{O}. Further, a current - (I_{O} - I_{L}) flows inside the measuring object wire P2, and a magnetic field (- H_{O} + H_{L}) is generated by the current - (I_{O} - I_{L}). Then, the magnetic flux Φ_{L} is generated in the magnetic core 1 by the two magnetic fields H_{O} and (- H_{O} + H_{L}). That is, the magnetic flux Φ_{L} represents a magnetic flux amount generated by a sum of inputted magnetic fields into the magnetic core 1. Next, the magnetic flux Φ_{L} generated in the magnetic core 1 leaks into the magnetic flux leakage section 3. Herein, when the magnetic flux having leaked into the magnetic flux leakage section 3 is referred to as a magnetic flux Φ_{HL}, the magnetic flux Φ_{HL} is detected by the magnetoelectric conversion element 20. The magnetoelectric conversion element 20 converts the detected magnetic flux Φ_{HL} to a voltage, and the converted voltage V_{ML} is outputted to the output signal processing circuit 32. The output signal processing circuit 32 then processes the voltage V_{ML}, and outputs to the input/output terminal 33 a voltage (V_{OL}) corresponding to a current value of the current having leaked. In this manner, the current sensor 30 detects leakage and measures a leakage amount.

### [6. Variations in magnetic core]

Next, a variety of shapes of the magnetic core will be described by means of FIGS. 25 to 48. However, the shapes of the magnetic core described here are merely examples, and these are not restrictive.

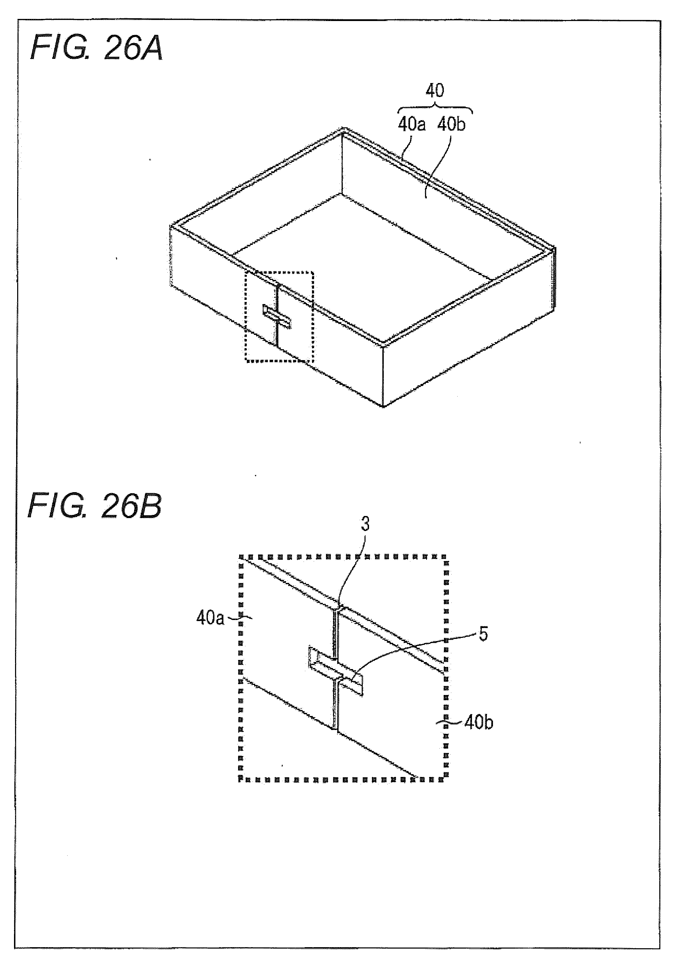

First, one shape of the magnetic core will be described by means of FIGS. 25 and 26. FIG. 25 shows one shape of the magnetic core according to the present embodiment, where FIG. 25A shows a top view and FIG. 25B shows a front view. Further, FIG. 26 shows a magnetic core 40 of FIG. 25, where FIG. 26A shows a perspective view and FIG. 26B shows an expanded view of the magnetic flux leakage section 3 and the element holding hole 5.

With reference to FIG. 25, the magnetic core 40 has a rectangular shape as seen from above, and has a rectangular shape as seen from front. Further, the magnetic core 40 is a single layered type formed by docking a first core section 40a and a second core section 40b both having a U shape. The first core section 40a and the second core section 40b are in intimate contact with each other on a surface constituting one surface of the rectangular shape (upper-side surface in the figure of FIG. 25A). Then, on the surface opposed to the above surface (lower-side surface in the figure of FIG. 25A), the first core section 40a and the second core section 40b are formed with the magnetic flux leakage section 3 and the element holding hole 5. Herein, the first open end plane of the first core section 40a and the second open end plane of the second core section 40b are spaced from each other, thereby to form the magnetic flux leakage section 3 (FIG. 25B). Then, the element holding hole 5 is formed by the first element holding hole provided on the first open end plane and the second element holding hole provided on the second open end plane. The element holding hole 5 is formed in a radiation direction with respect to a current flowing through the measuring object wire (not shown), and penetrates the first core section 40a and the second core section 40b (FIG. 26).

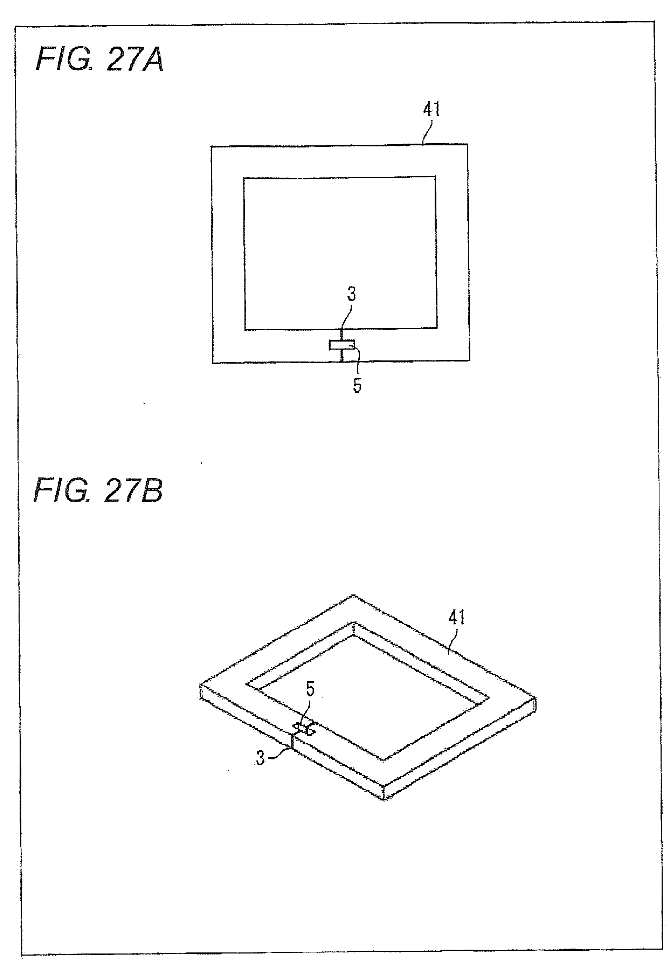

FIG. 27 shows one shape of the magnetic core, where FIG. 27A shows a top view and FIG. 27B shows a perspective view.

A magnetic core 41 is configured of a single layered integrated type having a rectangular shape as seen from above. In the magnetic core 41, the element holding hole 5 is formed in parallel with a current flowing through the measuring object wire (not shown), and penetrates a first core section 41 a and a second core section 41 b. Further, the first open end plane and the second open end plane are spaced from each other, and not in contact with each other.

As seen from the comparison between FIGS. 25 an 27, the element holding hole may be formed in either in the radiation direction with respect to the current flowing through the measuring object wire (not shown) or in parallel with the current. Further, the thickness of the magnetic core as seen from above may be large or small. As thus described, the shape of the magnetic core is not restricted to a specific shape, but can be a variety of shapes. Hence the shape of the magnetic core can be changed as appropriate in accordance with a design of the apparatus, a layout of the inside of the current sensor, and the like.

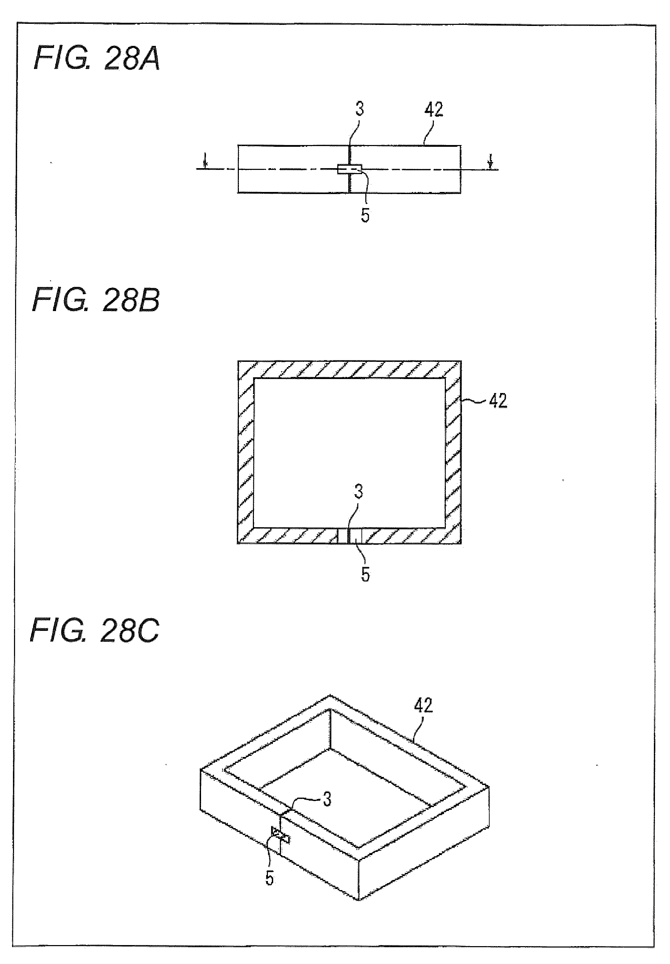

Next, another example will be described. FIGS. 28 to 30 are views each showing a state where the range of presence of the element holding hole in the magnetic core is different when the shape of the magnetic core is the same. Descriptions will be provided below sequentially from FIG. 28.

FIG. 28 shows one shape of the magnetic core, where FIG. 28A shows an elevational view, FIG. 28B shows a top view, and FIG. 28C shows a perspective view.

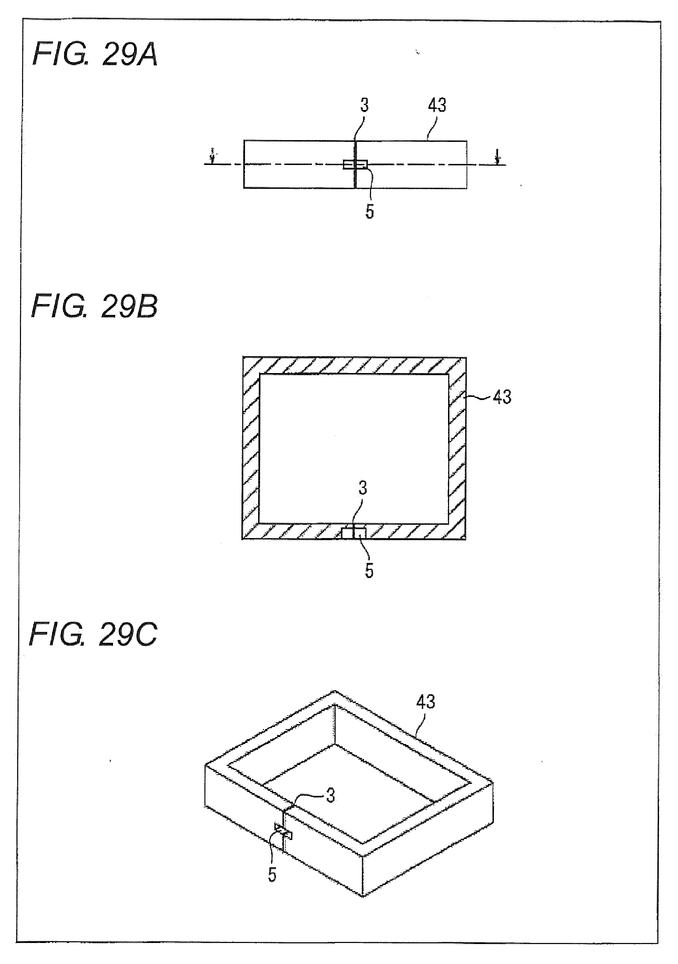

A magnetic core 42 is configured of a single layered integrated type having a rectangular shape as seen from above. In the magnetic core 42, the element holding hole 5 is formed in parallel with a current flowing through the measuring object wire (not shown), and penetrates the magnetic core 42. A diagonally shaded area in FIG. 28B shows the magnetic core, and the other area shows the element holding hole 5. This also applies to FIG. 29 and after. In addition, as shown in the figure, the first open end plane and the second open end plane are spaced from each other, and not in contact with each other.

FIG. 29 shows one shape of the magnetic core, where FIG. 29A shows an elevational view, FIG. 29B shows a top view, and FIG. 29C shows a perspective view.

A magnetic core 43 is different from the magnetic core 42 of FIG. 28 in the following respect. That is, the element holding hole 5 does not penetrate the magnetic core 42. The side of the measuring object wire (not shown) is closed and the opposite side to the measuring object wire is open. That is, only one side of the element holding hole 5 is open in the radiation direction with respect to the current flowing through the measuring object wire.

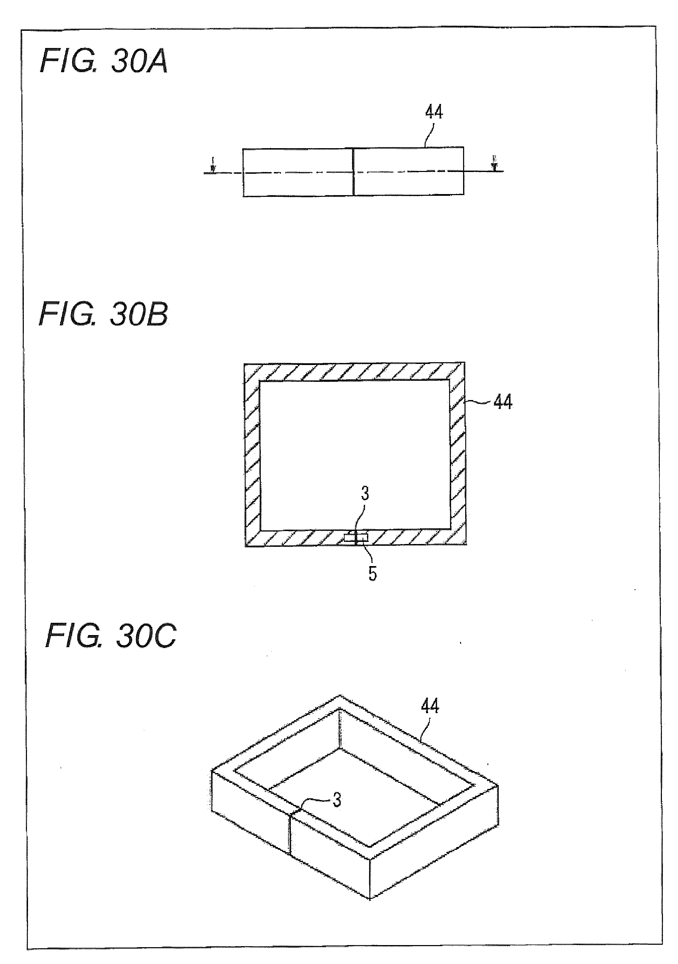

FIG. 30 shows one shape of the magnetic core, where FIG. 30A shows an elevational view, FIG. 30B shows a top view, and FIG. 30C shows a perspective view.

A magnetic core 44 is different from the magnetic core 43 of FIG. 29 in the following respect. That is, both sides of the element holding hole 5 is closed in the radiation direction with respect to the current flowing through the measuring object wire. Therefore, the element holding hole 5 is enclosed inside the magnetic core 44, and is communicated with the outside only through the magnetic flux leakage section 3.

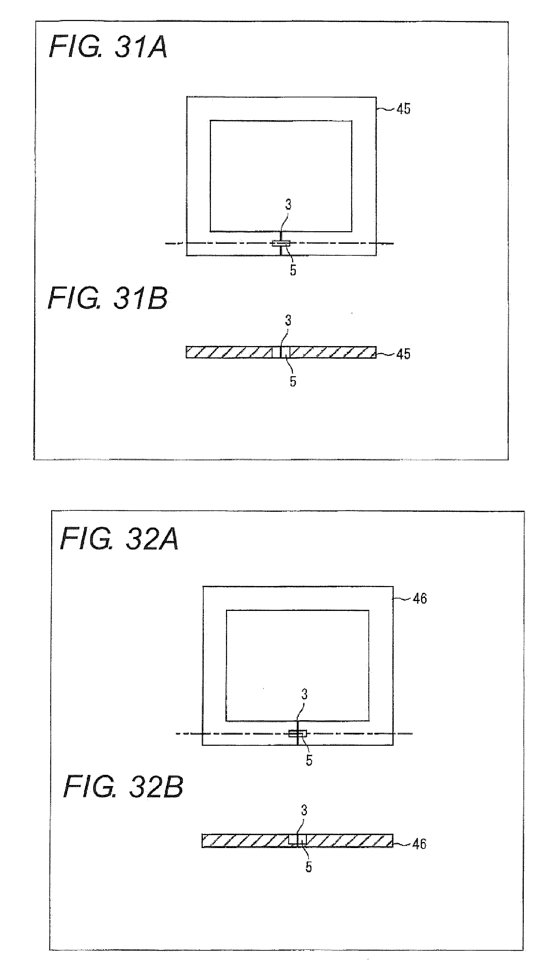

In the above, the examples were described using FIGS. 28 to 30, where the range of presence of the element holding hole in the magnetic core can be different when the shape of the magnetic core is the same. Similarly, examples will be described using FIGS. 31 to 33, where the range of presence of the element holding hole in the magnetic core can be different when the shape of the magnetic core is the same.

FIG. 31 shows one shape of the magnetic core, where FIG. 31A shows a top view and FIG. 31B shows an elevational view.

A magnetic core 45 is configured of a single layered integrated type having a rectangular shape as seen from above. In the magnetic core 45, the element holding hole 5 is formed in parallel with a current flowing through the measuring object wire (not shown), and penetrates the magnetic core 45. In addition, the first open end plane and the second open end plane are spaced from each other, and not in contact with each other.

FIG. 32 shows one shape of the magnetic core, where FIG. 32A shows a top view and FIG. 32B shows an elevational view.

A magnetic core 46 is different from the magnetic core 45 of FIG. 31 in the following respect. That is, the element holding hole 5 does not penetrate the magnetic core 46. The lower side in the figure of FIG. 32B is closed, and the upper side of FIG. 32B is open. That is, only one side of the element holding hole 5 is open in the parallel direction to the current flowing through the measuring object wire.

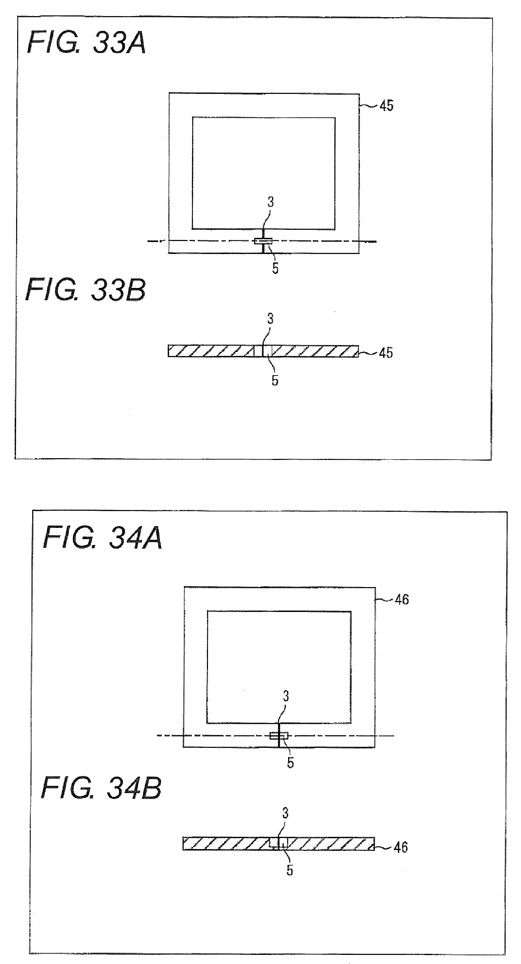

FIG. 33 shows one shape of a magnetic core 47, where FIG. 33A shows a top view and FIG. 33B shows an elevational view.

A magnetic core 47 is different from the magnetic core 46 of FIG. 32 in the following respect. That is, both upper and lower sides of the element holding hole 5 are closed in the parallel direction to the current flowing through the measuring object wire. Therefore, the element holding hole 5 is enclosed inside the magnetic core 47, and is communicated with the outside through the magnetic flux leakage section 3.

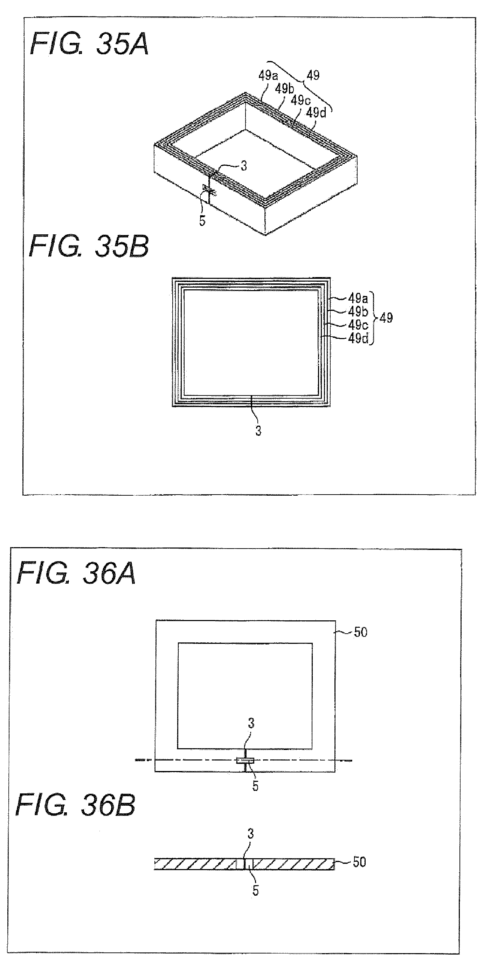

In the above, the examples were described using FIGS. 31 to 33, where the range of presence of the element holding hole in the magnetic core can be different when the shape of the magnetic core is the same. Next, as another example, examples where the magnetic core is a single layered type or stacked type will be described by means of FIGS. 34 and 35.

FIG. 34 shows one shape of the magnetic core, where FIG. 34A shows a perspective view and FIG. 34B shows a top view.

A magnetic core 48 is configured of a single layered integrated type having a rectangular shape as seen from above. In the magnetic core 48, the element holding hole 5 is formed in the radiation direction with respect to a current flowing through the measuring object wire (not shown), and penetrates the magnetic core 48. In addition, the first open end plane and the second open end plane are spaced from each other, and not in contact with each other.

FIG. 35 shows one shape of the magnetic core, where FIG. 35A shows a perspective view and FIG. 35B shows a top view.

A magnetic core 49 is different from the magnetic core 48 of FIG. 34 in the following respect. That is, a magnetic core 49 has a rectangular shape as seen from above, but is configured of a stacked type. More specifically, in the magnetic core 49, a magnetic core 49a, a magnetic core 49b, a magnetic core 49c and a magnetic core 49d are stacked in this order toward a direction of the measuring object wire (not shown).

That is, the magnetic core according to the present embodiment can be realized not only by the single layered integrated type, but also by the stacked type. It should be noted that, although the magnetic core 49 is made up of a four layered structure of magnetic cores 49a to 49d, it may be made up of a two layered structure, a three layered structure, or not less than five layered structure.

Next, as still another example, examples where the magnetic core is a single layered type or stacked type will be described by means of FIGS. 36 to 38.

FIG. 36 shows one shape of the magnetic core, where FIG. 36A shows a top view and FIG. 36B shows an elevational view.

A magnetic core 50 is configured of a single layered integrated type having a rectangular shape as seen from above. In the magnetic core 50, the element holding hole 5 is formed in parallel with a current flowing through the measuring object wire (not shown), and penetrates the magnetic core 50. In addition, the first open end plane and the second open end plane are spaced from each other, and not in contact with each other.

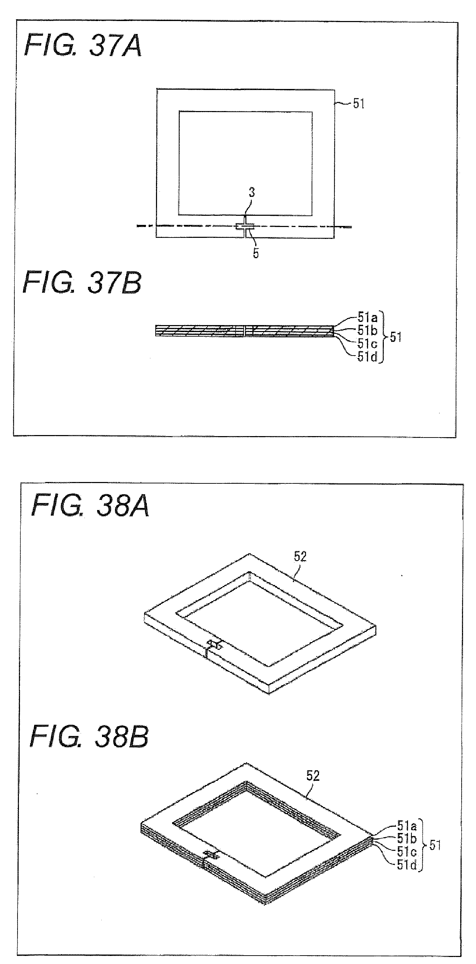

FIG. 37 shows one shape of the magnetic core, where FIG. 37A shows a top view and FIG. 37B shows an elevational view.

A magnetic core 51 is different from the magnetic core 50 of FIG. 36 in the following respect. That is, as shown in FIG. 37B, in the magnetic core 51, a magnetic core 51a, a magnetic core 51b, a magnetic core 51c and a magnetic core 51d are stacked in this order in parallel with the measuring object wire.

That is, the magnetic core according to the present embodiment can be realized not only by the single layered integrated type, but also by the stacked type. It should be noted that, although the magnetic core 51 is made up of a four layered structure of magnetic cores 51a to 51d, it may be made up of a two layered structure, a three layered structure, or not less than five layered structure.

FIG. 38 shows one shape of the magnetic core according to the present embodiment, where FIG. 38A shows a perspective view of the magnetic core 50 of FIG. 36 and FIG. 38B shows a perspective view of the magnetic core 51 of FIG. 37.

As seen from the figure, the magnetic core 50 is formed of the integrated type, whereas the magnetic core 51 is formed of a stacked structure where a plurality of magnetic cores are stacked in parallel with the measuring object wire. As thus described, the shape of the magnetic core is not restricted to a specific shape, but can be a variety of shapes. Hence the shape of the magnetic core can be changed as appropriate in accordance with a design of the apparatus, a layout of the inside of the current sensor, and the like.

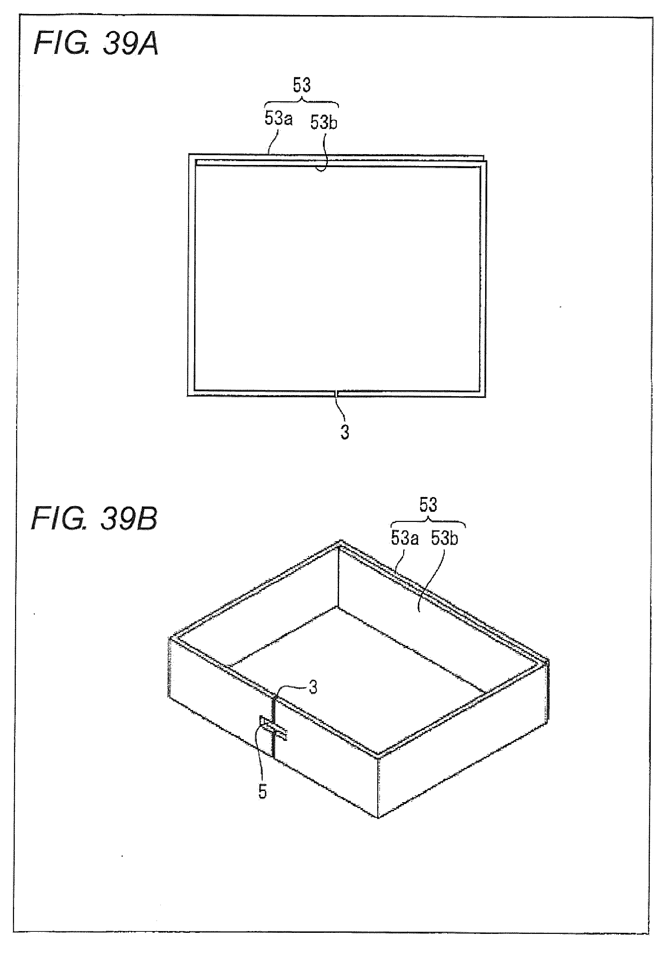

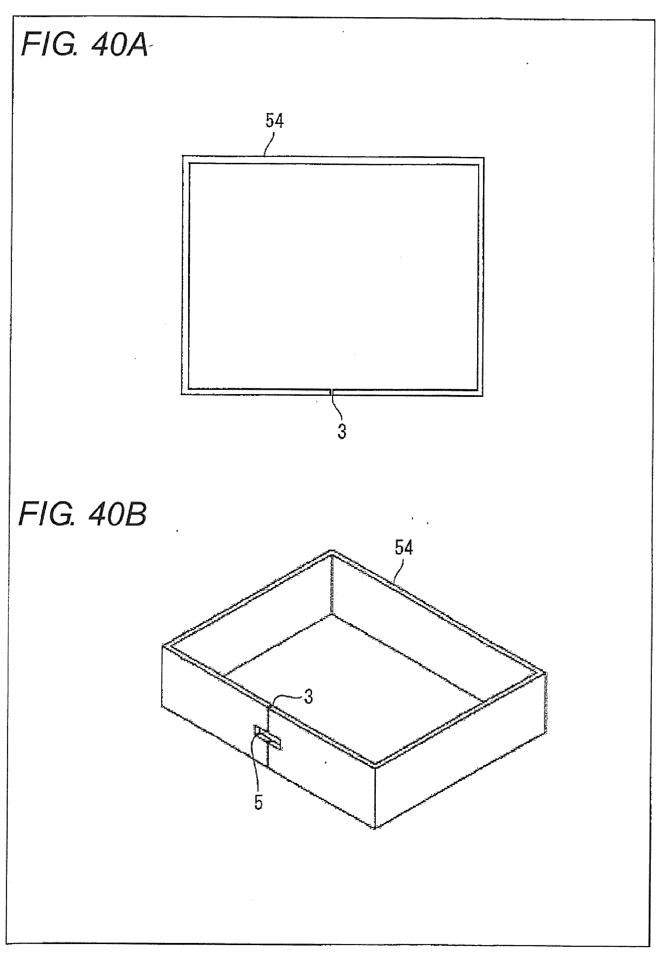

Next, another example will be described by means of FIGS. 39 and 40.

FIG. 39 shows one shape of the magnetic core, where FIG. 39A shows a top view and FIG. 39B shows a perspective view.

A magnetic core 53 has a substantially rectangular shape as seen from above. More specifically, the magnetic core 53 is a single layered type formed by docking a first core section 53a and a second core section 53b both having a U shape. The first core section 53a and the second core section 53b are in intimate contact with each other on a surface constituting one surface of the rectangular shape (upper-side surface in the figure). Then, on the surface opposed to the above surface (lower-side surface in the figure), the first core section 53a and the second core section 53b are formed with the magnetic flux leakage section 3 and the element holding hole 5. Herein, the first open end plane of the first core section 53a and the second open end plane of the second core section 53b are spaced from each other, thereby to form the magnetic flux leakage section 3. Then, the element holding hole 5 is formed by the first element holding hole provided on the first open end plane and the second element holding hole provided on the second open end plane. The element holding hole 5 is formed in the radiation direction with respect to a current flowing through the measuring object wire (not shown), and penetrates the first core section 53a and the second core section 53b.

FIG. 40 shows one shape of the magnetic core, where FIG. 40A shows a top view and FIG. 40B shows a perspective view.

A magnetic core 54 is configured of a single layered integrated type having a rectangular shape as seen from above. In the magnetic core 54, the element holding hole 5 is formed in the radiation direction with respect to a current flowing through the measuring object wire (not shown), and penetrates the magnetic core 54. In addition, the first open end plane and the second open end plane are spaced from each other, and not in contact with each other.

As thus described, the magnetic core can be realized as either the docked type or the integrated type.

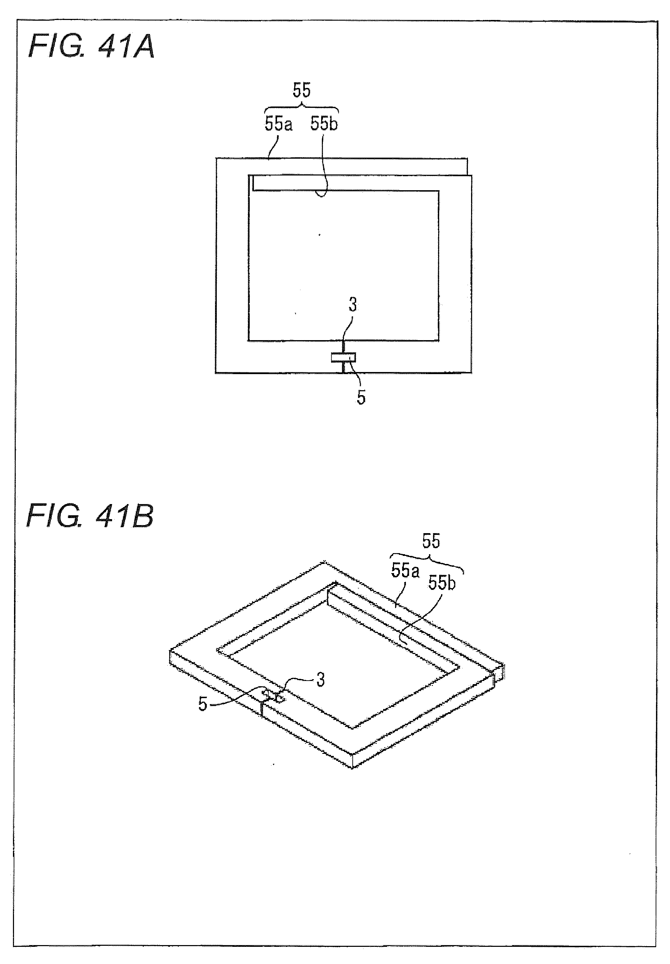

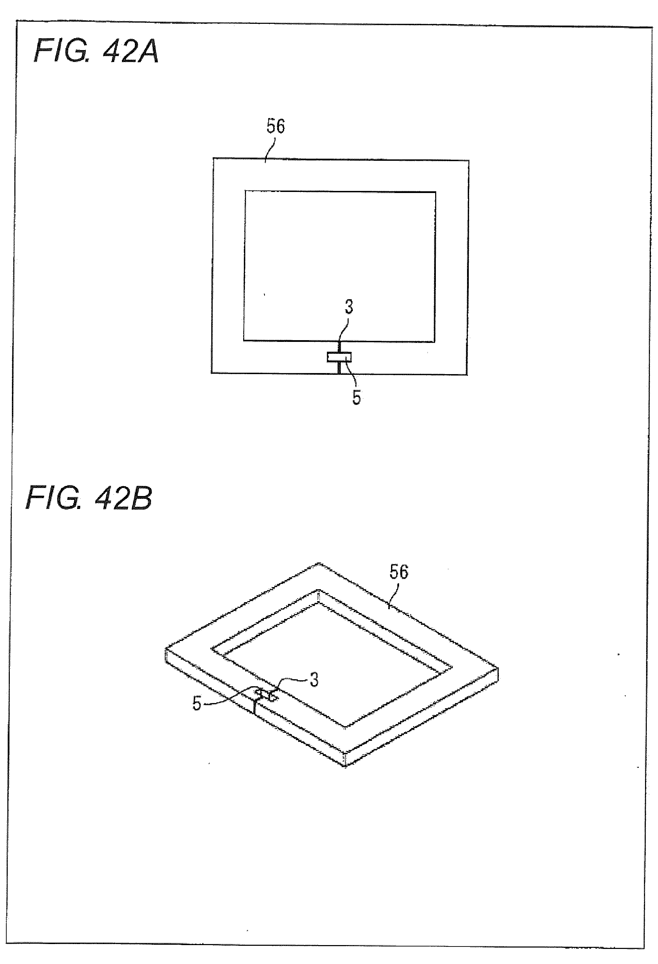

Next, another example will be described by means of FIGS. 41 and 42.

FIG. 41 shows one shape of the magnetic core, where FIG. 41A shows a top view and FIG. 41B shows a perspective view.

A magnetic core 55 has a substantially rectangular shape as seen from above. More specifically, the magnetic core 55 is a single layered type formed by docking a first core section 55a and a second core section 55b both having a U shape. The first core section 55a and the second core section 55b are in intimate contact with each other on a surface constituting one surface of the rectangular shape (upper-side surface in the figure). Then, on the surface opposed to the above surface (lower-side surface in the figure), the first core section 55a and the second core section 55b are formed with the magnetic flux leakage section 3 and the element holding hole 5. Herein, the first open end plane of the first core section 55a and the second open end plane of the second core section 55b are spaced from each other, thereby to form the magnetic flux leakage section 3. Then, the element holding hole 5 is formed by the first element holding hole provided on the first open end plane and the second element holding hole provided on the second open end plane. The element holding hole 5 is formed in parallel with a current flowing through the measuring object wire (not shown), and penetrates a first core section 55a and a second core section 55b.

FIG. 42 shows one shape of the magnetic core, where FIG. 42A shows a top view and FIG. 42B shows a perspective view.

A magnetic core 56 is configured of a single layered integrated type having a rectangular shape as seen from above. In the magnetic core 56, the element holding hole 5 is formed in parallel with a current flowing through the measuring object wire (not shown), and penetrates the magnetic core 56. In addition, the first open end plane and the second open end plane are spaced from each other, and not in contact with each other.

As thus described, the magnetic core according to the present embodiment can be realized as either the docked type or the integrated type.

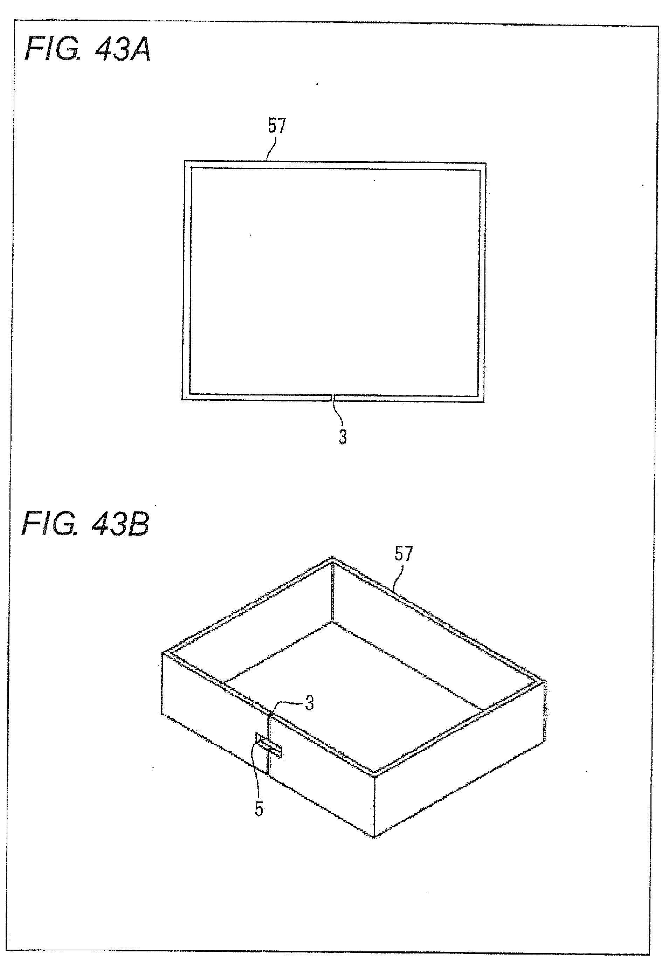

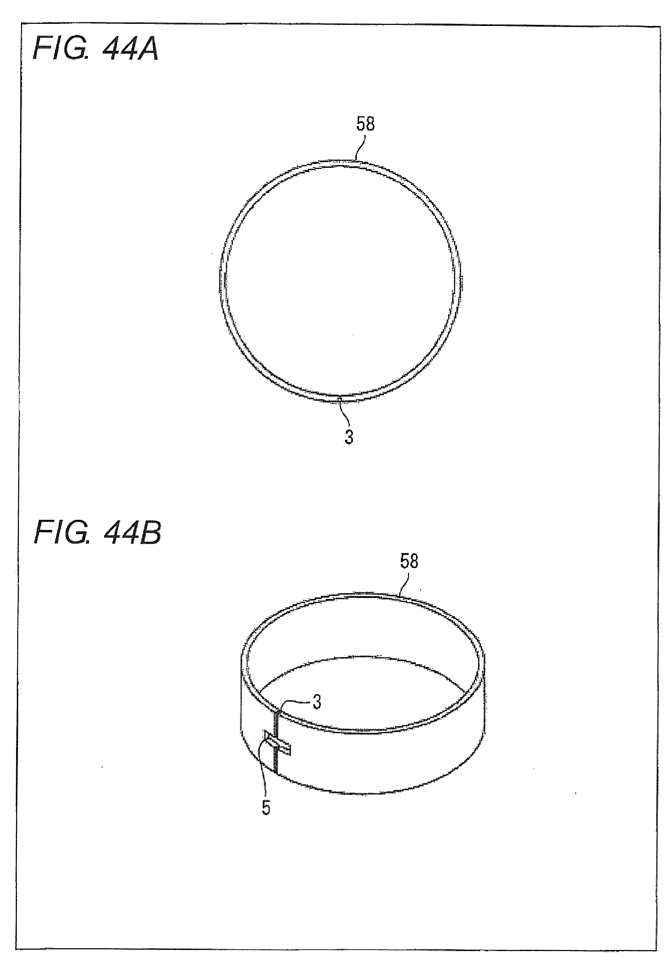

Next, another example will be described by means of FIGS. 43 and 44.

FIG. 43 shows one shape of the magnetic core, where FIG. 43A shows a top view and FIG. 43B shows a perspective view.

A magnetic core 57 is configured of a single layered integrated type having a rectangular shape as seen from above. In the magnetic core 57, the element holding hole 5 is formed in the radiation direction with respect to a current flowing through the measuring object wire (not shown), and penetrates the magnetic core 57. In addition, the first open end plane and the second open end plane are spaced from each other, and not in contact with each other.

FIG. 44 shows one shape of the magnetic core, where FIG. 44A shows a top view and FIG. 44B shows a perspective view.

A magnetic core 58 is configured of a single layered integrated type having a circular shape as seen from above. In the magnetic core 58, the element holding hole 5 is formed in the radiation direction with respect to a current flowing through the measuring object wire (not shown), and penetrates the magnetic core 58. In addition, the first open end plane and the second open end plane are spaced from each other, and not in contact with each other.

As thus described, the magnetic core according to the present embodiment can be realized as in rectangular shape, circular shape, or another shape though not described here.

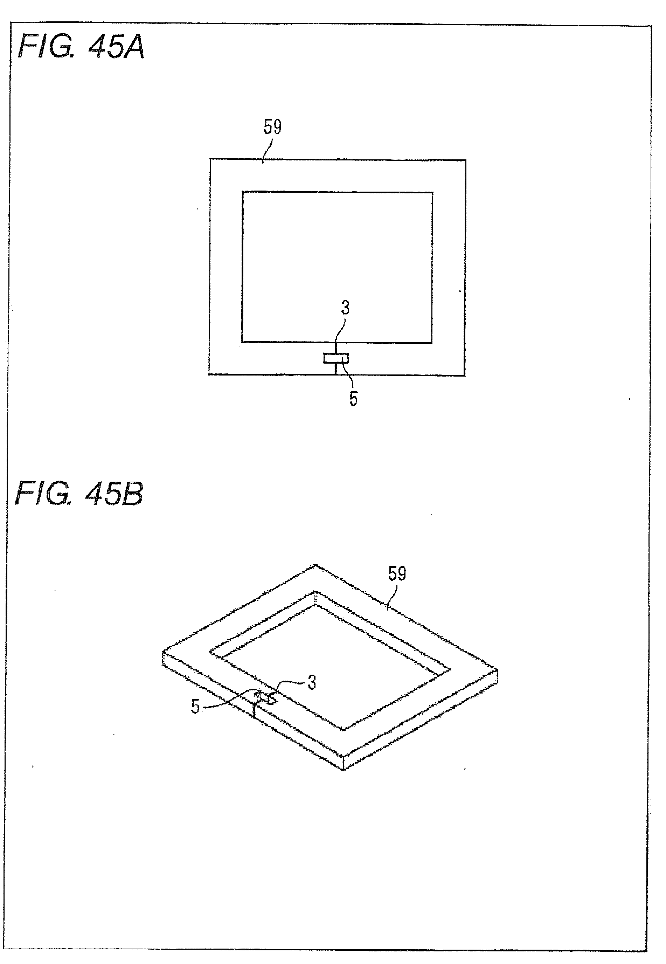

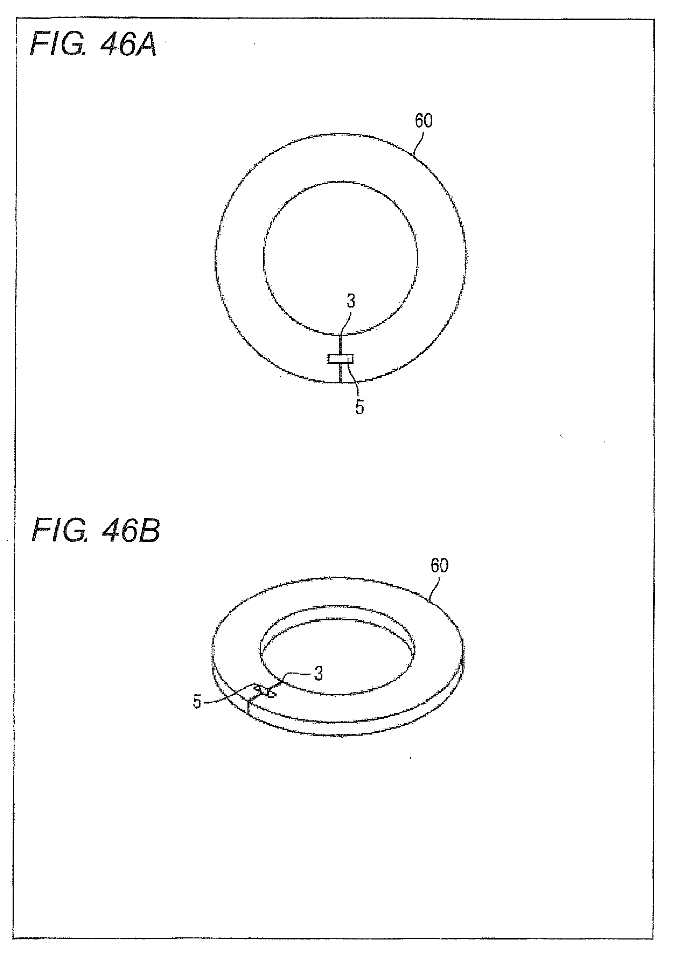

Next, another example will be described by means of FIGS. 45 and 46.

FIG. 45 shows one shape of the magnetic core, where FIG. 45A shows a top view and FIG. 45B shows a perspective view.

A magnetic core 59 is configured of a single layered integrated type having a rectangular shape as seen from above. In the magnetic core 59, the element holding hole 5 is formed in parallel with a current flowing through the measuring object wire (not shown), and penetrates the magnetic core 59. In addition, the first open end plane and the second open end plane are spaced from each other, and not in contact with each other.

FIG. 46 shows one shape of the magnetic core, where FIG. 46A shows a top view and FIG. 46B shows a perspective view.

A magnetic core 60 is configured of a single layered integrated type having a circular shape as seen from above. In the magnetic core 60, the element holding hole 5 is formed in parallel with a current flowing through the measuring object wire (not shown), and penetrates the magnetic core 60. In addition, the first open end plane and the second open end plane are spaced from each other, and not in contact with each other.

As thus described, the magnetic core according to the present embodiment can be realized as in rectangular shape, circular shape, or another shape though not described here.

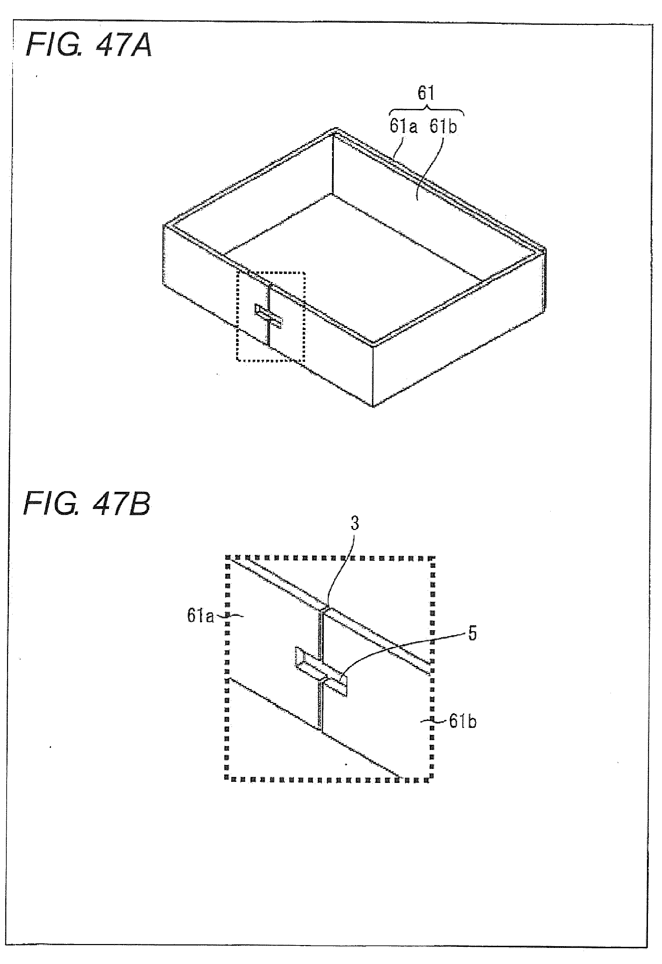

Next, another example will be described by means of FIGS. 47 and 48.

FIG. 47 shows one shape of the magnetic core according to the present embodiment, where FIG. 47A shows a perspective view and FIG. 47B shows an expanded view of the magnetic flux leakage section 3 and the element holding hole 5.

A magnetic core 61 has a rectangular shape as seen from above. More specifically, the magnetic core 61 is a single layered type formed by docking a first core section 61 a and a second core section 61 b both having a U shape. The first core section 61 a and the second core section 61 b are in intimate contact with each other on a surface constituting one surface of the rectangular shape (upper-side surface in the figure). Then, on the surface opposed to the above surface (lower-side surface in the figure), the first core section 61 a and the second core section 61b are formed with the magnetic flux leakage section 3 and the element holding hole 5. Herein, the first open end plane of the first core section 61 a and the second open end plane of the second core section 61 b are spaced from each other, thereby to form the magnetic flux leakage section 3. Then, the element holding hole 5 is formed by the first element holding hole provided on the first open end plane and the second element holding hole provided on the second open end plane. The element holding hole 5 is formed in the radiation direction with respect to a current flowing through the measuring object wire (not shown), and penetrates the first core section 61 a and the second core section 61 b.

FIG. 48 shows one shape of the magnetic core according to the present embodiment, where FIG. 48A shows a perspective view and FIG. 48B shows an expanded view of the magnetic flux leakage section 3 and the element holding hole 5.

A magnetic core 62 is in common with the magnetic core 61 of FIG. 47 in that a single layered type formed by docking a first core section 61a and a second core section 61 b both having a U shape. However, in the magnetic core 62, the first open end plane of a first core section 62a and the second open end plane of a second core section 62b are not spaced from each other, and are in contact with each other. That is, the magnetic core 62 is formed in the abutting structure. Then, as described with reference to FIG. 10, even having the abutting structure, the magnetic core 62 can acquire a similar effect to the magnetic core in the gap structure.

In the above, the variety of shapes of the magnetic core according to the present embodiment were described by means of FIGS. 25 to 48. These shapes each show one example of the present embodiment, and a shape other than those described here can be naturally applied in accordance with a design of the apparatus, a layout of the inside of the current sensor, and the like.

Next, it will be described that the thickness of the magnetic core in the radiation direction with respect to a current flowing through the measuring object wire does not have an influence on the sensitivity of the entire current sensor provided with the magnetic core.

As an example, a comparison is made between the thicknesses of the magnetic cores as seen from the top in FIGS. 1A and FIG. 39A. It is found at this time that the magnetic core 53 of FIG. 39A has a smaller thickness than the magnetic core 1 of FIG. 1A. However, this is not indicative that the magnetic core 53 has a lower sensitivity than the magnetic core 1.

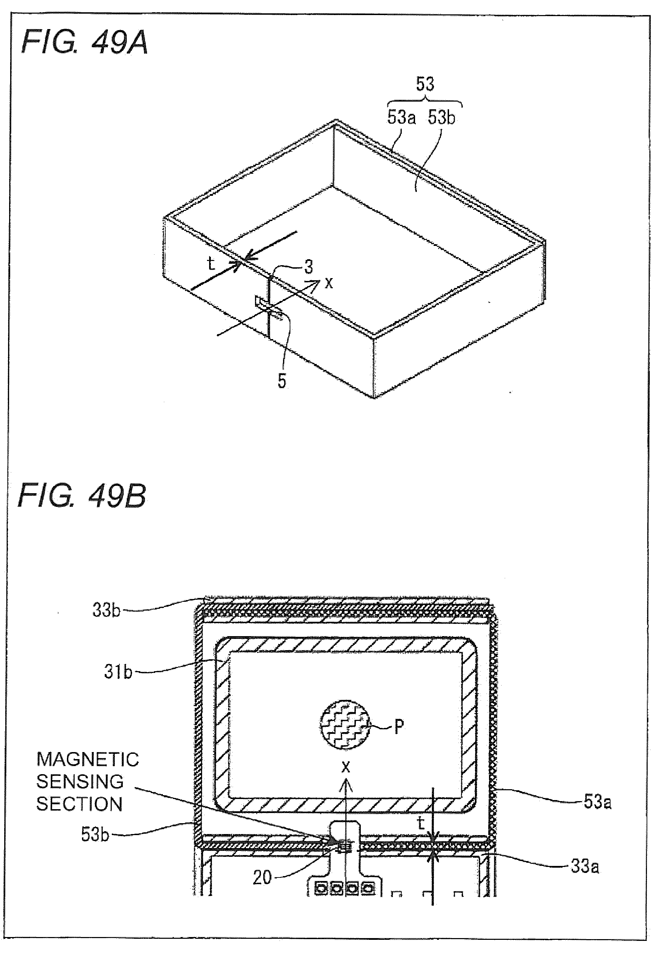

FIG. 49 is a view for explaining in reference to the magnetic core 53 in FIG. 39 that the sensitivity of the current sensor provided with the magnetic core does not decrease even with the magnetic core having a small thickness, where FIG. 49A is a perspective view, and FIG. 49B is a schematic view. It is to be noted that in FIG. 49A, the radiation direction with respect to a current flowing through the measuring object wire (not shown) is taken as a direction x and the thickness of the magnetic core in the direction x is taken as a thickness t.

At this time, as shown in FIG. 49B, the thickness t of the magnetic core 53 is formed larger than the width of the magnetic sensing section of the magnetoelectric conversion element 20. Then, an amount of the magnetic flux inside the element holding hole 5 is almost constant in the x direction. Therefore, the sensitivity of the entire current sensor provided with the magnetic core 53 does not decrease even with the thickness t being small.

That is, since the amount of the magnetic flux inside the element holding hole is almost constant in the direction x, the sensitivity of the entire current sensor provided with the magnetic core does not decrease so long as the thickness t is larger than the width of the magnetic sensing section of the magnetoelectric conversion element 20. Therefore, as described above, even though the magnetic core 53 has a smaller thickness t than the magnetic core 1, it does not necessarily mean having an influence on the sensitivity of the entire current sensor provided with the magnetic core 53.

The present invention is not restricted to the foregoing embodiment, but a variety of modifications are possible in the range shown in the claims. That is, embodiments obtained by combining technical means having been appropriately modified in the range shown in the claims are included in the technical range of the present invention.

### [Supplement]

It is to be noted that the present invention may be realized in the following configurations.

The magnetic core according to the present invention is a magnetic core used for a current sensor, which may be configured to have: a first open end plane which is formed with a first element holding hole for holding a magnetoelectric conversion element; and a second open end plane which is formed with a second element holding hole for holding the magnetoelectric conversion element, and is opposed to the first open end plane.

The magnetic core according to the present invention has the first open end plane and the second open end plane which are opposed to each other. Then, the first element holding hole is formed on the first open end plane, the second element holding hole is formed on the second open end plane, and a magnetoelectric conversion element is held by the first element holding hole and the second element holding hole.

Therefore, due to the presence of the first open end plane and the second open end plane, namely the presence of a void section (hereinafter referred to as a "magnetic flux leakage section") between the first open end plane and the second open end plane, a magnetic flux is prone to leakage from the magnetic core toward the first element holding hole and the second element holding hole, and the magnetoelectric conversion element held in the first element holding hole and the second element holding hole can sense the leakage of the magnetic flux.

In addition, while the sensitivity of the magnetic core is more favorable with lower magnetic resistance of the magnetic flux leakage section, the magnetic resistance of the magnetic flux leakage section is lower with a smaller width of the magnetic flux leakage section (distance between the first open end plane and the second open end plane). In this respect, in a magnetic core according to the present invention, the magnetoelectric conversion element is held in the first element holding hole and the second element holding hole which are formed by the first open end plane and the second open end plane. Therefore, the distance between the first open end plane and the second open end plane is not made large to such a degree that the magnetoelectric conversion element is held therebetween. That is, the distance between the first open end plane and the second open end plane naturally becomes small. Accordingly, in the magnetic core according to the present invention, the magnetic flux leakage section has a small width and thus causes magnetic resistance of the magnetic flux leakage section to decrease, thereby allowing improvement in sensitivity of the current sensor that uses the magnetic core.

For such a reason, the magnetic core according to the present invention can solve the conventional problem described with reference to FIG. 17A (problem that the width of the cut-off section has to be made large for providing the magnetoelectric conversion element in the cut-off section, accompanied by deterioration in sensitivity of the magnetic core).

Further, in the magnetic core according to the present invention, the first element holding hole and the second element holding hole are formed not in positions along an outer edge of the magnetic core where a magnetic flux is resistant to leakage from the magnetic core, but on the first open end plane and the second open end plane. For the above reason, in the magnetic core according to the present invention, the magnetoelectric conversion element is held in the first element holding hole and the second element holding hole where a magnetic flux is prone to leakage from the magnetic core, whereby it is possible to collect a larger amount of magnetic flux generated due to a minute current, so as to improve the sensitivity.

Therefore, the magnetic core according to the present invention can solve the conventional problem described with reference to FIG. 17B (problem that, due to placement of the magnetoelectric conversion element in the notch section formed along the outer edge of the magnetic core, a magnetic flux is resistant to leakage from the magnetic core and the magnetoelectric conversion element detects a minute magnetic flux, thereby to cause deterioration in sensitivity of the magnetic core).

As thus described, with the above configuration formed, a magnetic core capable of enhancing the detection sensitivity of the current sensor can be realized as the magnetic core according to the present invention.

Further, the magnetic core according to the present invention may be configured that the magnetoelectric conversion element is held in the first element holding hole and the second element holding hole such that a magnetic sensing direction of the magnetoelectric conversion element is a circumferential direction of the magnetic core.

With the above configuration formed, it is possible to make small the first element holding hole and the second element holding hole in the thickness direction of the magnetoelectric conversion element (thickness direction of the magnetic core which is vertical to the circumferential direction of the magnetic core), which hold the magnetoelectric conversion element. With smaller widths of the first element holding hole and the second element holding hole in the thickness direction of the magnetic core, a magnetic flux that leaks from the magnetic core is amplified, and hence with the above configuration formed, it is possible to enhance the sensitivity of the magnetoelectric conversion element. Accordingly, a magnetic core capable of further enhancing the detection sensitivity of the current sensor can be realized as the magnetic core according to the present invention.

Further, in the magnetic core according to the present invention, the distance between the first open end plane and the second open end plane is preferably smaller than 2 mm.

In light of a size of a typical magnetoelectric conversion element, when the distance between the first open end plane and the second open end plane is not smaller than 2mm, the magnetoelectric conversion element cannot be held in the first element holding hole and the second element holding hole.

Thereat, with the above configuration formed, such an effect is exerted that the magnetoelectric conversion element can be held in the first element holding hole and the second element holding hole, and the magnetoelectric conversion element can reliably sense a magnetic flux leaking from the magnetic core to the first element holding hole and the second element holding hole.

Further, when a bottom surface of the first element holding hole 5a is referred to as a first bottom surface (reference numeral of 16 in FIG 9) and a bottom surface of the second element holding hole 5b is referred to as a second bottom surface (reference numeral of 17 in FIG 9), the first element holding hole 5a and the second element holding hole 5b may have hole widths (L2) in the thickness direction of the held magnetoelectric conversion element 20 not more than 1.75 times as large as the side-surface distance (L1) between the first bottom surface 16 and the second bottom surface 17.

Moreover, the element holding hole has been described using an expression "hole". Although this expression "hole" may be used synonymously with so-called "groove", "hole" is used in the present specification as a uniform expression.

Further, the term "holding hole" is used as the meaning of a space required for arrangement, storage, and the like of the magnetoelectric conversion element.

### INDUSTRIAL APPLICABILITY

The present invention relates to a magnetic core capable of enhancing detection sensitivity of a current sensor, a current sensor provided with the magnetic core, and a current measuring method performed using the current sensor provided with the magnetic core.

## Claims

1. A magnetic core used for a current sensor, having:
a first open end plane which is formed with a first element holding hole for holding a magnetoelectric conversion element; and
a second open end plane which is formed with a second element holding hole for holding the magnetoelectric conversion element, and is opposed to the first open end plane.

2. The magnetic core according to claim 1, wherein the magnetoelectric conversion element is held in the first element holding hole and the second element holding hole such that a magnetic sensing direction of the magnetoelectric conversion element is a circumferential direction of the magnetic core.

3. The magnetic core according to claim 1, wherein the first element holding hole and the second element holding hole are filled with a low permeability material having a lower permeability than the magnetic core.

4. The magnetic core according to claim 3, wherein a space between the first open end plane and the second open end plane is filled with a low permeability material having a lower permeability than the magnetic core.

5. The magnetic core according to claim 3, wherein the low permeability material is a ferrite-containing epoxy resin, a magnetic fluid or air.

6. The magnetic core according to claim 4, wherein the low permeability material is a ferrite-containing epoxy resin, a magnetic fluid or air.

7. The magnetic core according to claim 1, wherein, when a side surface opposed to a side surface forming the second element holding hole among side surfaces forming the first element holding hole is regarded as a first side surface and a side surface opposed to the first side surface among side surfaces forming the second element holding hole is regarded as a second side surface, the first element holding hole and the second element holding hole preferably have hole widths in a thickness direction of the held magnetoelectric conversion element not more than 1.75 times as large as the distance between the first side surface and the second side surface.

8. The magnetic core according to claim 1, wherein the distance between the first open end plane and the second open end plane is smaller than 2 mm.

9. The magnetic core according to claim 1, wherein parts of the first open end plane and the second open end plane are in contact with each other.

10. The magnetic core according to claim 1, wherein the first element holding hole and the second element holding hole are respectively extended on the first open end plane and the second open end plane along a parallel direction to the thickness direction of the magnetic core.

11. The magnetic core according to claim 1, wherein the first element holding hole and the second element holding hole are respectively extended on the first open end plane and the second open end plane along a vertical direction to the thickness direction of the magnetic core.

12. A current sensor, comprising the magnetic core according to any one of claims 1 to 11.

13. A current measuring method, wherein a current value of a current flowing through a measuring object wire by a current sensor provided with the magnetic core according to claim 1.
